# EUROPEAN PATENT APPLICATION

(11) **EP 1 859 955 A1**
(43) Date of publication of application: **28.11.2007**
(21) Application number: 06713209.2
(22) Date of filing: 07.02.2006
(51) Int. Cl.: B41N 1/14, B41C 1/055, G03F 7/00, G03F 7/004, G03F 7/20, G03F 7/38

(54) **LITHOGRAPHIC PRINTING PLATE MAKING METHOD AND IMAGE EXPOSING SYSTEM**

(30) Priority: 14.03.2005 JP 2005070719
(71) Applicant: Konica Minolta Medical & Graphic, Inc., Tokyo 163-0512 (JP)
(72) Inventor: TAKAMUKI, Yasuhiko, kawa-machi, Hachioji-shi, Tokyo, 1928505 (JP)
(74) Representative: Gille Hrabal Struck Neidlein Prop Roos
(86) International application number: PCT/JP2006/302066
(87) International publication number: WO 2006/098100

(57) **Abstract**

The present invention is possible to provide a plate-making method of a planographic printing plate to easily obtain the planographic printing plate exhibiting on-press developability, together with printing durability and image reproduction, and an imagewise exposure device used for the planographic printing plate. Disclosed is a plate-making method of a planographic printing plate possessing the steps of imagewise exposing a printing plate material comprising a support and provided thereon, an on-press developable image formation layer to light; and conducting a development treatment on a planographic printing press to prepare the planographic printing plate, wherein laser light for the imagewise exposure has a wavelength of 350 - 450 nm, and laser light for a heating process conducted before the development treatment has a wavelength of 700 - 1500 nm.

## Description

### TECHNICAL FIELD

The present invention relates to a plate-making method of a planographic printing plate employing a processless printing plate material used in a computer-to-plate (CTP) system, and an imagewise exposure device.

### BACKGROUND

In recent years, a CTP system has been developed and put into practical use, which directly writes digital image data on a photosensitive planographic printing plate employing a laser light source in a process of manufacturing a printing plate for off-set printing.

In a printing field in which relatively high printing durability is required, a planographic printing plate material is known which comprises an aluminum support and provided thereon, a negatively working image formation layer comprising an image recording layer containing a polymerizable compound.

On the one hand, a photosensitive planographic printing plate for CTP to record digital data employing a laser is known which comprises a photopolymerizable image formation layer containing titanocene and a specific dye as a polymerizable initiator described in Japanese Patent O.P.I. Publication Nos. 9-80750 and 10-101719, for example. However, the photosensitive planographic printing plate capable of being treated under lighter yellow light (safe light) was demanded since a plate-making process to prepare a printing plate had to be treated under safe light of dark red light because of using a visible light having a comparatively long-wavelength as a light source.

Further, high output and downsized blue violet lasers having an emission wavelength in the range of short wavelength, for example, have been readily available on the market. Safe light handling has been realized via development of photosensitive planographic printing plates suitable at the above laser wavelength, and a photopolymerizable type photosensitive planographic printing plate suitable for laser exposure at a wavelength of 350 - 450 nm is disclosed (Patent Documents 1 - 3, for example). However, the plate-making method employing the printing plate material requires a wet development treatment employing an aqueous alkali solution or such after an exposure process.

On the other hand, as a printing plate material used for a CTP system, a printing plate material has been sought which does not require any development employing a developer containing specific chemicals (such as alkalis, acids, and solvents), and can be applied to a conventional printing press. Known are a chemical-free type printing plate material such as a phase change type printing plate material requiring no development process, a printing plate material which can be processed with water or a neutral processing liquid comprised mainly of water, or a printing plate material capable of being developed on a printing press at initial printing stage and requiring no development process; and a printing plate material called a processless printing plate material.

As the above-described processless printing plate material, known are a printing plate material having an image formation layer containing a polymer having a photocurable group and an acidic group (refer to Patent Document 4), a heat mode recording method processless printing plate material comprising an aluminum support and provided thereon, a on-press developable image formation layer (refer to Patent Document 5) and so forth.

Also known is a negatively working image formation material comprising an infrared absorbent, a radical generating agent, a radically polymerizable compound and a binder polymer, wherein the material is heated at 60 - 120 °C for 1 - 20 seconds after imagewise exposure employing an infrared laser, that is, a heating process is conducted after exposure to light to improve printing durability (refer to Patent Document 6).

However, a plate-making method employing this printing plate material was possible to be utilized for an on-press developable processless printing plate material for CTP to form comparatively high-definition images, but there were still problems such as insufficient printing durability, insufficient dot reproduction from a small dot to a shadow portion as insufficient image reproduction, and so forth.

Patent Document 1: Japanese Patent O.P.I. Publication No. 2003-21901

Patent Document 2: Japanese Patent O.P.I. Publication No. 2000-147763

Patent Document 3: Japanese Patent O.P.I. Publication No. 2002-202598

Patent Document 4: Published Japanese translation of PCT international Publication No. 11-504435

Patent Document 5: Japanese Patent O.P.I. Publication No. 2001-277742

Patent Document 6: Japanese Patent O.P.I. Publication No. 2001-175006

### DISCLOSURE OF THE INVENTION

### PROBLEMS TO BE SOLVED BY THE PRESENT INVENTION

It is an object of the present invention to provide a plate-making method of a planographic printing plate to easily obtain the planographic printing plate exhibiting on-press developability, together with printing durability and image reproduction, and an imagewise exposure device used for the planographic printing plate.

### MEANS TO SOLVE THE PROBLEMS

The above object of the present invention is accomplished by the following structures.
(Structure 1) A plate-making method of a planographic printing plate comprising the steps of imagewise exposing a printing plate material comprising a support and provided thereon, an on-press developable image formation layer to light; and conducting a development treatment on a planographic printing press to prepare the planographic printing plate, wherein laser light for the imagewise exposure has a wavelength of 350 - 450 nm, and laser light for a heating process conducted before the development treatment has a wavelength of 700 - 1500 nm.
(Structure 2) The plate-making method of a planographic printing plate of Structure 1, wherein heating in the heating process is conducted in 0.1 seconds before or after the imagewise exposure.
(Structure 3) The plate-making method of a planographic printing plate of Structure 2, wherein the heating in the heating process and the imagewise exposure are conducted at the same time.
(Structure 4) The plate-making method of a planographic printing plate of any one of Structures 1 - 3, wherein the heating process is an imagewise heating process with laser light.
(Structure 5) The plate-making method of a planographic printing plate of any one of Structures 1 - 4, wherein the image formation layer comprises (A) a photopolymerizable initiator, (B) a binder, (C) a polymerizable ethylenic unsaturated bond-containing compound and (D) a dye exhibiting an absorption maximum in a wavelength of 350 - 450 nm.
(Structure 6) The plate-making method of a planographic printing plate of any one of Structures 1 - 5, wherein the binder is a water-soluble polymeric compound.
(Structure 7) The plate-making method of a planographic printing plate of any one of Structures 1 - 6, wherein the image formation layer comprises a light-to-heat conversion material.
(Structure 8) The plate-making method of a planographic printing plate of any one of Structures 1 - 7, wherein the imagewise exposure is conducted on a printing press.
(Structure 9) An imagewise exposure device used in the plate-making method of a planographic printing plate of any one of Structures 1 - 8, comprising a device of imegewise exposure to laser light having a wavelength of 350 - 450 nm and a devive of exposure to laser light having a wavelength of 700 - 1500 nm.

### EFFECT OF THE INVENTION

The structures of the present invention can provide a plate-making method of a planographic printing plate to easily obtain the planographic printing plate exhibiting on-press developability, together with printing durability and image reproduction, and an imagewise exposure device used for the planographic printing plate.

### BRIEF DESCRIPTION OF THE DRAWINGS

[Fig. 1] A lateral view showing an embodiment relating to a plate-making method and an imagewise exposure device of the present invention.
[Fig. 2] A schematic diagram showing an embodiment relating to a plate-making method of the present invention.
[Fig. 3] A schematic diagram showing an embodiment relating to a plate-making method of the present invention.

### EXPLANATION OF NUMERALS

1 Printing press
2 Image exposure device employing laser light having a wavelength of 350 - 450 nm
3 Exposure device employing laser light having a wavelength of 700 - 1500 nm
4 and 5 Laser light generator
6 Mirror
7 Semi-transparent mirror
8 Imagewise exposure device
9 Exposure control device
11 and 12 Ink supply roller
13 Dampening water supply roller
14 Plate cylinder
15 Printing plate material
16 Blanket
17 Printing paper
18 Impression cylinder
21 and 22 Laser light

### DESCRIPTION OF THE PREFERRED EMBODIMENTS

Next, the present invention will be described in detail.

It is a feature in the present invention to provide a plate-making method of a planographic printing plate comprising the steps of imagewise exposing a printing plate material comprising a support and provided thereon, an on-press developable image formation layer to light; and conducting a development treatment on a planographic printing press to prepare the planographic printing plate, wherein laser light for the imagewise exposure has a wavelength of 350 - 450 nm, and laser light for a heating process conducted before the development treatment has a wavelength of 700 - 1500 nm.

The present invention is specifically effective in the case of the image formation layer comprises (A) a photopolymerizable initiator, (B) a binder, (C) a polymerizable ethylenic unsaturated bond-containing compound and (D) a dye exhibiting an absorption maximum in a wavelength of 350 - 450 nm, and is further effective in the case of employing a water-soluble polymeric compound as the binder.

### (Imagewise exposure)

Imagewise exposure is conducted employing laser light having a wavelength of 350 - 450 nm.

The laser light having a wavelength of 350 - 450 nm means that an emission wavelength is within this wavelength range, and is laser light generated by a stably oscillating laser, and examples of emitting elements for the laser include a combination of a guiding wavelength conversion element and an AlGaAs or InGaAs semiconductor (380 - 450 nm), a combination of a guiding wavelength conversion element and an AlGaInP or InGaAs semiconductor (300 - 350 nm), AlGaInN (350 - 450 nm), and another pulse laser such as an N₂ laser (337 nm, pulse: 0.1 - 10 mJ), an XeF laser (351 nm, pulse: 10 - 250 mJ) or such.

As the laser of the present invention, an AlGaInN semiconductor laser (an InGaN type semiconductor laser available on the market, 400 - 410 nm) is usable in view of wavelength characteristics.

The total output of a utilized laser is preferably 35 - 200 mW, and more preferably 50 - 180 mW. This laser may be used singly, or a plurality of the lasers may also be used coaxially employing optical fibers. In addition, the laser output when using a plurality of the lasers is the total output.

A laser scanning method by means of a laser beam includes a method of scanning on an outer surface of a cylinder, a method of scanning on an inner surface of a cylinder and a method of scanning on a plane. In the method of scanning on an outer surface of a cylinder, laser beam exposure is conducted while a drum around which a recording material is wound is rotated, in which main scanning is represented by the rotation of the drum, while sub-scanning is represented by the movement of the laser beam.

In the method of scanning on an inner surface of a cylinder, a recording material is fixed on the inner surface of a drum, a laser beam is emitted from the inside, and main scanning is carried out in the circumferential direction by rotating a part of or an entire part of an optical system, while sub-scanning is carried out in the axial direction by moving straight a part of or an entire part of the optical system in parallel with a shaft of the drum. In the method of scanning on a plane, main scanning by means of a laser beam is carried out through a combination of a polygon mirror, a galvano mirror and an Fθ lens, and sub-scanning is carried out by moving a recording medium.

Imagewise exposure can be conducted employing an imagewise exposure device equipped with a laser light generator for imagewise exposure to laser light.

### (Heating process)

In a plate-making method of the present invention, a planographic on-press development treatment is conducted after a printing plate material is imagewise exposed to light, but a heating process is conducted via exposure to laser light having a wavelength of 700 - 1500 nm before this development treatment.

The laser light having a wavelength of 700 - 1500 nm means that an emission wavelength is within this wavelength range, and is laser light generated by a stably oscillating laser, and examples thereof include a gas laser, a semiconductor laser emitting in the near-infrared region and so forth.

Heating in the heating process of the present invention is conducted via exposure to laser in the above-described wavelength range, the laser for this heating is preferably a semiconductor laser, and examples of commercially available semiconductors include AlGaAs, GaAs, InGaAs, AlGaInP and so forth. The semiconductor thereof having a typical emission wavelength such as 780 nm, 830 nm, 860 - 880 nm, 940 - 950 nm, or 1310 - 1500 nm is preferably usable in view of wavelength characteristics.

The total output of a utilized laser is preferably 5 - 5000 mW, and more preferably 100 - 3000 mW.

This laser may be used singly, or a plurality of the lasers may also be used coaxially employing optical fibers. In addition, the laser output when using a plurality of the lasers is the total output.

Heating in the heating process before a development treatment is preferably conducted immediately before or after imagewise exposure, or the heating and the imagewise exposure are preferably conducted at the same time. Specifically, heating in the heating process is preferably conducted in 0.1 seconds before or after the imagewise exposure.

The imagewise exposure is commonly conducted via scanning exposure, but in the present invention, the 0.1 seconds before or after the imagewise exposure means a duration from 0.1 seconds before starting the imagewise exposure to 0.1 seconds after terminating the imagewise exposure. The imagewise exposure duration is also included.

In the present invention, heating is preferably conducted within 0.1 seconds after image exposure, but specifically, the heating and the image exposure are preferably conducted at the same time.

In the present invention, both the total exposure and imagewise exposure may be allowed to be used for a heating process, but the imagewise exposure is specifically preferable in view of image reproduction.

The imagewise exposure is conducted in such a way that imagewise exposed portions are exposed to light for the heating process, and it becomes possible by adjusting an exposure position for heating and exposure timing.

Specifically, laser for imagewise exposure and laser for heating each are arranged to be independently placed so as to scan and expose, and also to scan along the same path on a drum by delaying a desired duration. The adjustment can be made by delaying the same imagewise signal by an amount of the desired duration to obtain an output.

In cases where the imagewise exposure and exposure for the heating process are conducted at the same time, an imagewise signal output obtained by the scanning laser for the imagewise exposure may be adjusted to exactly the same imagewise signal output as that of the scanning laser for heating.

An exposure device used for a heating process generates laser light for the heating process, and exposure can be conducted employing the exposure device having an exposure device.

Preferably utilized is an imagewise exposure device comprising a device of imegewise exposure to laser light having a wavelength of 350 - 450 nm and a device of exposure to laser light having a wavelength of 700 - 1500 nm for a plate-making method of the present invention.

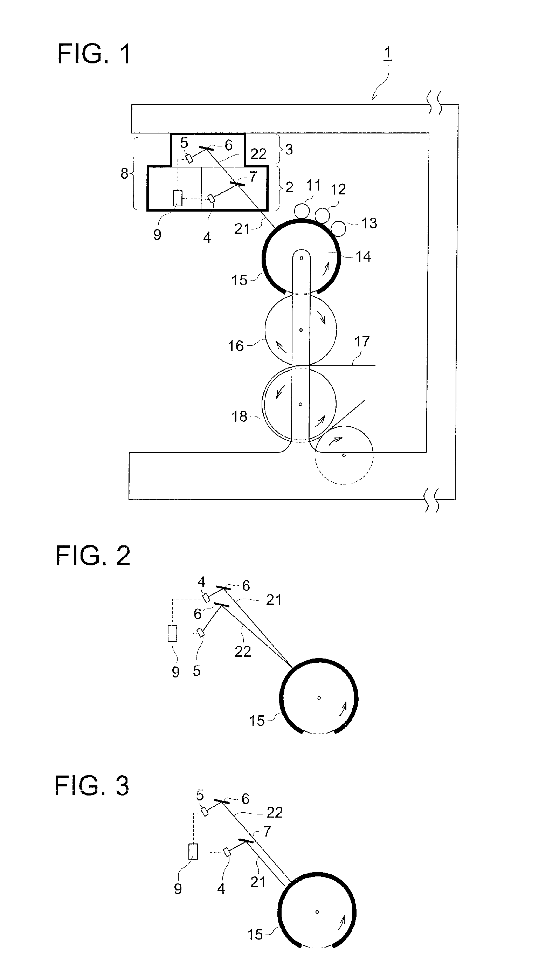

An example of an embodiment relating to a plate-making method and an imagewise exposure device of the present invention is shown in Fig. 1.

Printing plate material 15 is placed on plate cylinder 14 installed in printing press 1. Imagewise exposure device 8 comprises device 2 of imegewise exposure to laser light having a wavelength of 350 - 450 nm and device 3 of exposure to laser light having a wavelength of 700 - 1500 nm for a heating process.

Device 2 of imegewise exposure is equipped with laser light generator 4 and semi-transparent mirror 7, and device 3 of exposure for a heating process is equipped with laser light generator 5 and mirror 6.

Printing plate material 15 placed on plate cylinder 14 is imagewise exposed to laser light 21 generated by laser light generator 4 under the condition controlled by exposure control device 9 while rotating printing plate material 15 with the plate cylinder, and is heated with laser light 22 generated by laser light generator 5.

Imagewise exposure device 8 is equipped with exposure control device 9, and exposure control device 9 holds data of imagewise exposure information. The exposure conditions such as exposure timing, an exposure position, an exposure intensity, the number of plate cylinder rotations and so forth, and the heating condition are controlled by data of the imagewise exposure information, laser light generator information, and printing press information such as the number of plate cylinder rotations and so forth.

In the present invention, in cases when the imagewise exposure and the exposure for a heating process are conducted at the same time, these can be carried out employing an apparatus coaxially placed for laser light having a wavelength of 350 - 450 nm and laser light having a wavelength of 700 - 1500 nm to printing plate material 15 placed on plate cylinder 14 via semi-transparent mirror 7, as shown in Fig. 1.

An example of heating after the imagewise exposure is shown in Fig. 2, and an example of heating before the imagewise exposure is shown in Fig. 3. Imagewise heating is conducted by controlling exposure timing of laser light generated with laser light generators 4 and 5 via exposure control device 9 in Figs. 2 and 3.

### (Image formation layer)

An on-press developable image formation layer of the present invention means an image formation layer in which non-image portions of the image formation layer are removed by dampening water, or dampening water and ink during printing after imagewise exposure, and printable images can be formed.

The present invention is specifically effective in cases where the image formation layer comprises comprises (A) a photopolymerizable initiator, (B) a binder, (C) a polymerizable ethylenic unsaturated bond-containing compound and (D) a dye exhibiting an absorption maximum in a wavelength of 350 - 450 nm.

Further, the present invention is specifically effective in cases where the binder is a water-soluble polymeric compound.

### ((A) photopolymerizable initiator)

A photopolymerizable initiator of the present invention is one capable of initiating polymerization of a polymerizable ethylenic unsaturated bond-containing compound via imagewise exposure, and preferably usable examples thereof include a titanocene compound, a monoalkyltriarylborate compound, an iron arene complex compound and a polyhalogenated compound. Of these, an iron arene complex compound and a polyhalogenated compound are preferable in view of being treated under lighter yellow light.

As the titanocene compounds, there are those described in Japanese Patent O.P.I. Publication Nos. 63-41483 and 2-291. Preferred examples of titanocene compounds include bis(cyclopentadienyl)-Ti-di-chloride, bis(cyclopentadienyl)-Ti-bis-phenyl, bis(cyclopentadienyl)-Ti-bis-2,3,4,5,6-pentaflurophenyl, bis(cyclopentadienyl)-Ti-bis-2,3,5,6-tetrafluorophenyl, bis(cyclopentadienyl)-Ti-bis-2,4,6-trifluorophenyl, bis(cyclopentadienyl)-Ti-bis-2,6-difluorophenyl, bis(cyclopentadienyl)-Ti-bis-2,4-difluorophenyl, bis(methylcyclopentadienyl)-Ti-bis-2,3,4,5,6-pentafluorophenyl, bis(methylcyclopentadienyl)-Ti-bis-2,3,5,6-tetrafluorophenyl, bis(methylcyclopentadienyl)-Ti-bis-2,6-difluorophenyl (IRUGACURE 784, produced by Ciba Speciality Chemicals Co.), bis(cyclopentadienyl)-bis(2,4,6-trifluoro-3-(pyry-1-yl)phenyl)titanium, and bis(cyclopentadienyl)-bis(2,4,6-trifluoro-3-(2-5-dimethylpyry-1-yl)phenyl)titanium.

As the monoalkyltriaryl borate compounds, there are those described in Japanese Patent O.P.I. Publication Nos. 62-150242 and 62-143044. Preferred examples of the monoalkyltriaryl borate compounds include tetra-n-butyl ammonium n-butyl-trinaphthalene-1-yl-borate, tetra-n-butyl ammonium n-butyl-triphenyl-borate, tetra-n-butyl ammonium n-butyl-tri-(4-tert-butylphenyl)-borate, tetra-n-butyl ammonium n-hexyl-tri-(3-chloro-4-methylphenyl)-borate, and tetra-n-butyl ammonium n-hexyl-tri-(3-fluorophenyl)-borate.

As the iron-arene complexes, there are those disclosed in Japanese Patent O.P.I. Publication No. 59-219307.

Preferred examples of the iron-arene complex include η-benzene-(η-cyclopentadienyl)iron hexafluorophosphate, η-cumene-(η-cyclopentadienyl)iron hexafluorophosphate, η-fluorene-(η-cyclopentadienyl)iron hexafluorophosphate, η-naphthalene-η-cyclopentadienyl)iron hexafluorophosphate, η-xylene-η-cyclopentadienyl)iron hexafluorophosphate, and η-benzene-η-cyclopentadienyl)iron tetrafluoroborate.

As the polyhalogenated compound, preferably used is a compound having a trihalgenated methyl group, a dihalogenated methyl group or a dihalogenated methylene group. An oxadiazole compound having in the oxadiazole ring the group described above as the substituent or a polyhalogenated compound represented by the following Formula (1) is provided.

Formula (1) R¹-CY₂-(C=O)-R², wherein R¹ represents a hydrogen atom, a halogen atom, an alkyl group, an aryl group, an acyl group, an alkylsulfonyl group, an arylsulfonyl group, an iminosulfonyl group or a cyano group; R² represents a monovalent substituent, provided that R¹ and R² may combine with each other to form a ring; and Y represents a halogen atom.

Specific examples of the structure represented by Formula (1) include the following compounds from BR1 to BR66. In addition, for these compounds, compounds in which bromine is replaced by chlorine as a halogen atom are also preferably usable in the present invention.

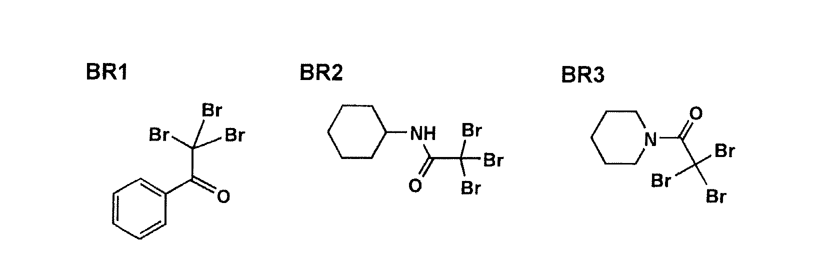

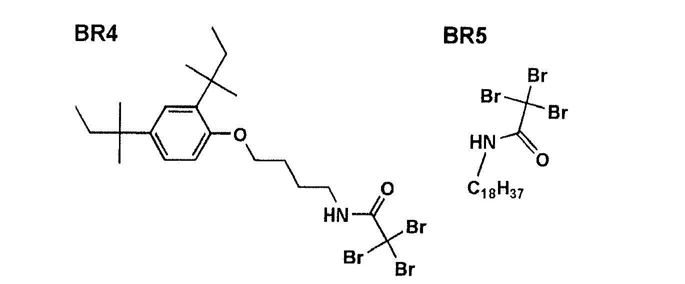

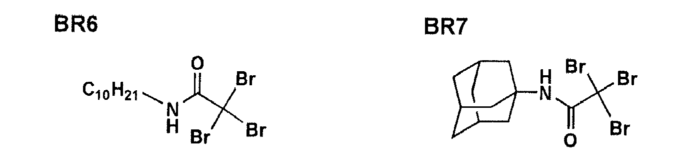

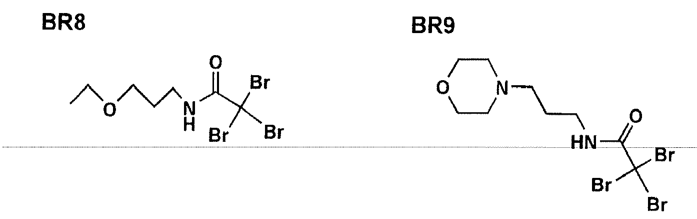

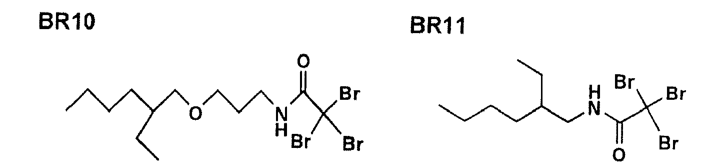

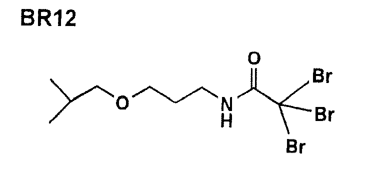

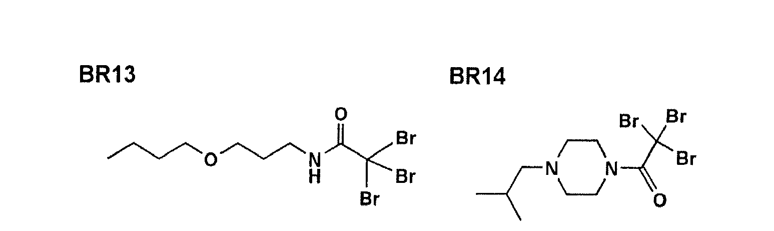

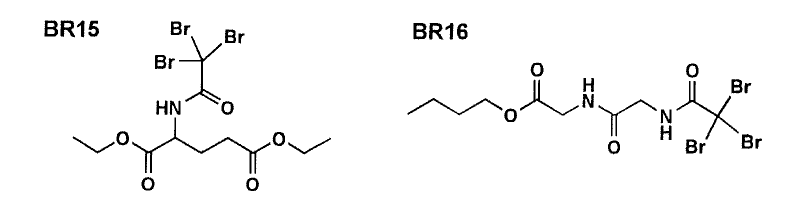

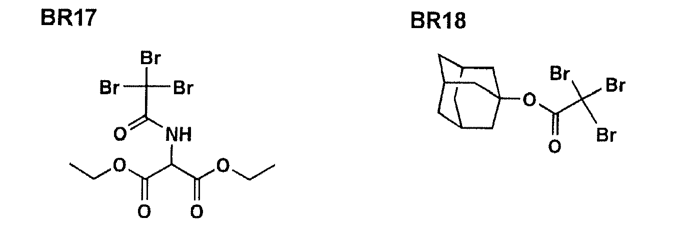

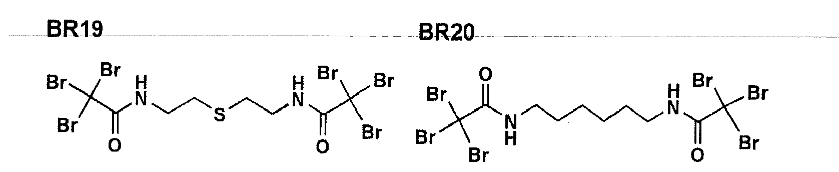

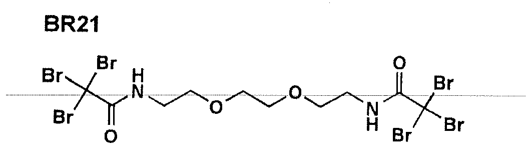

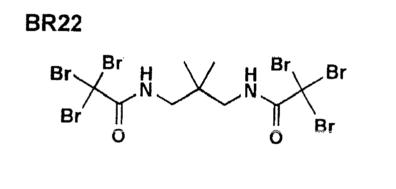

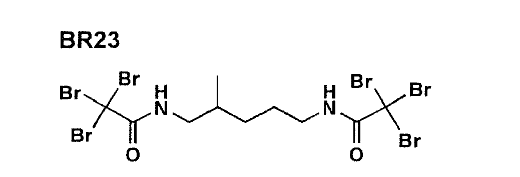

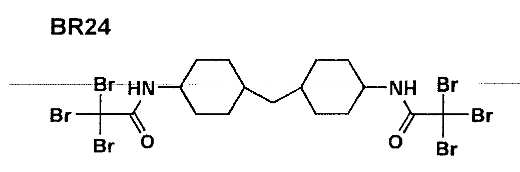

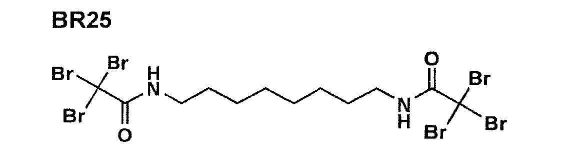

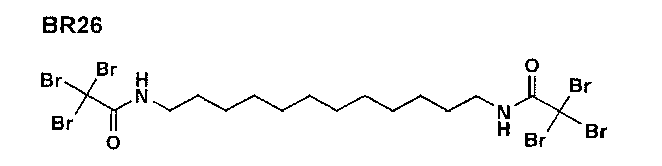

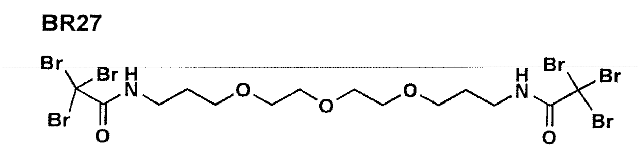

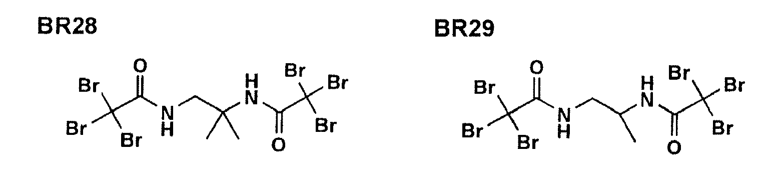

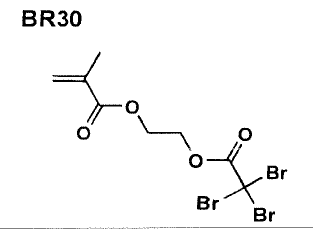

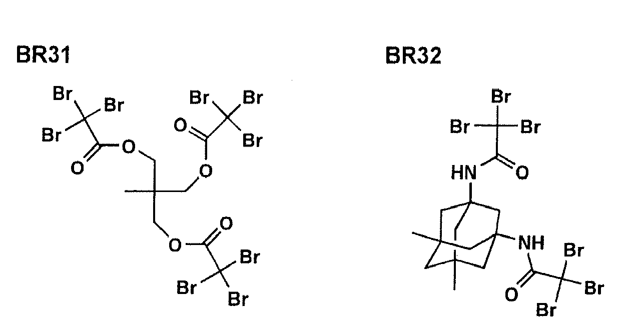

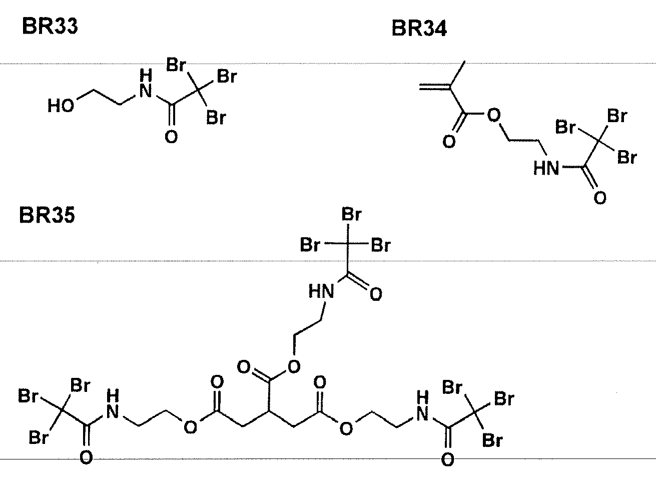

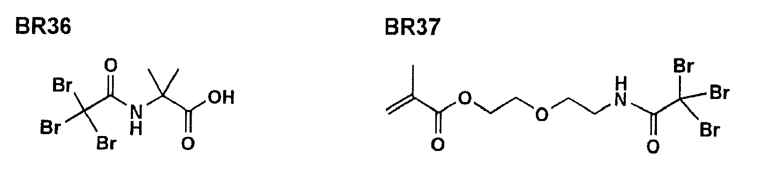

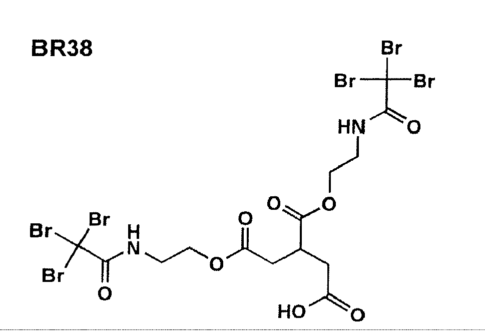

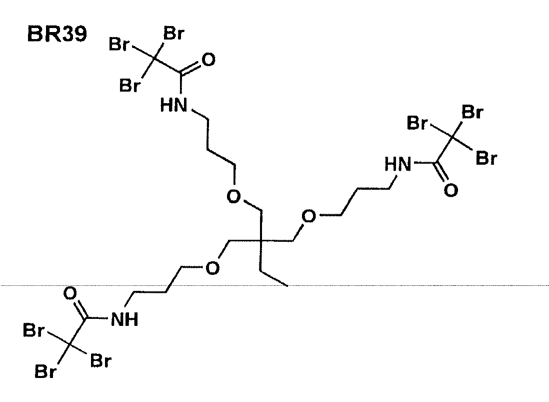

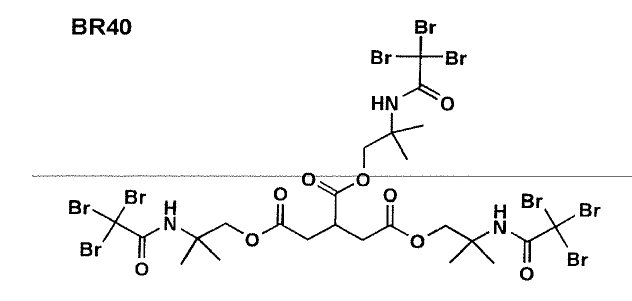

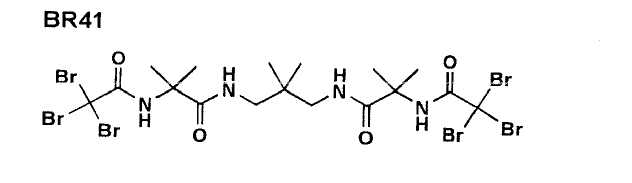

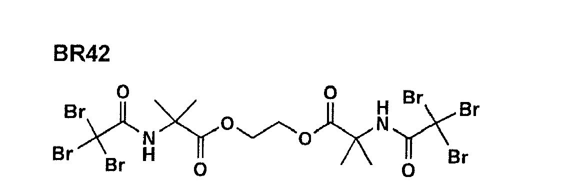

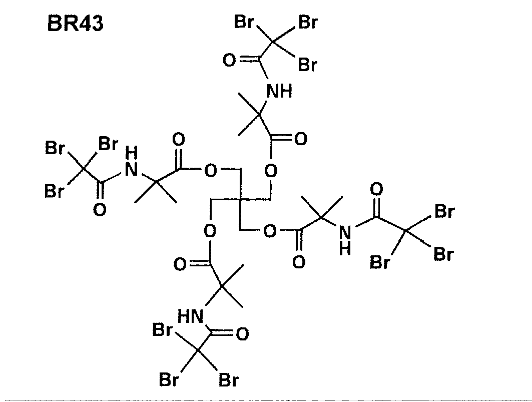

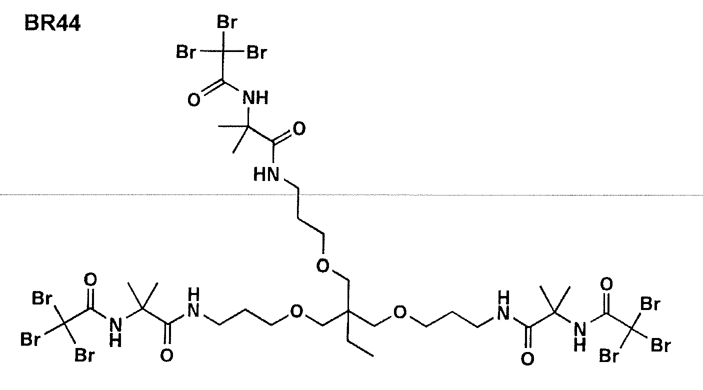

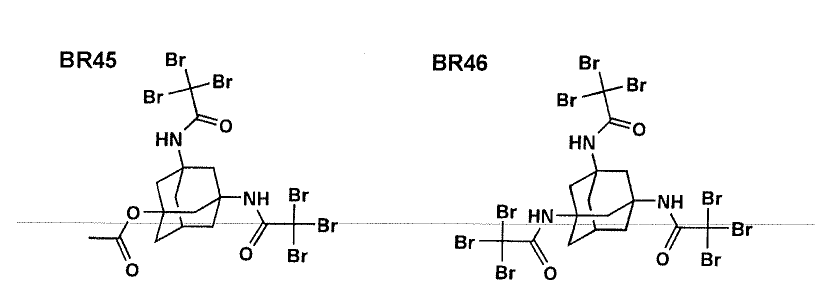

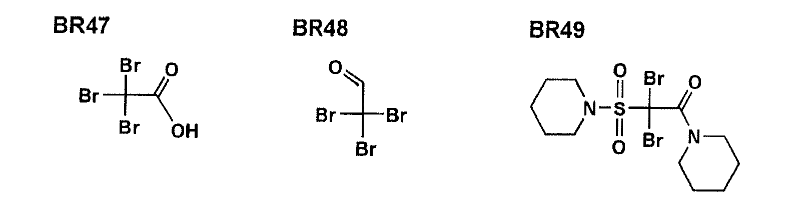

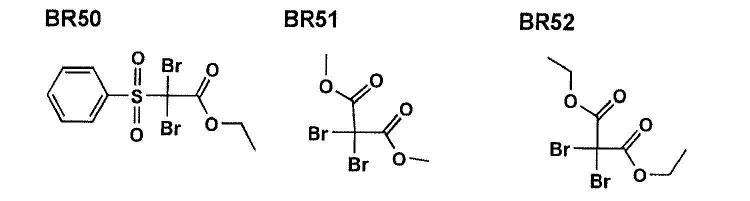

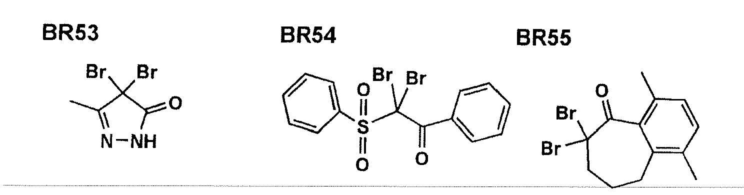

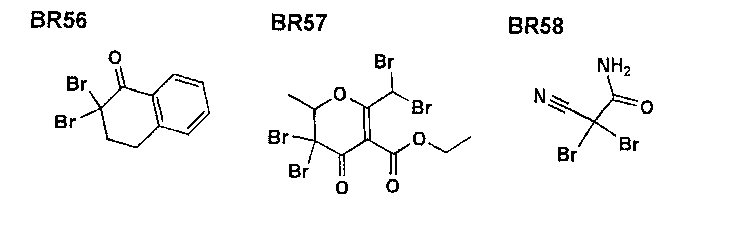

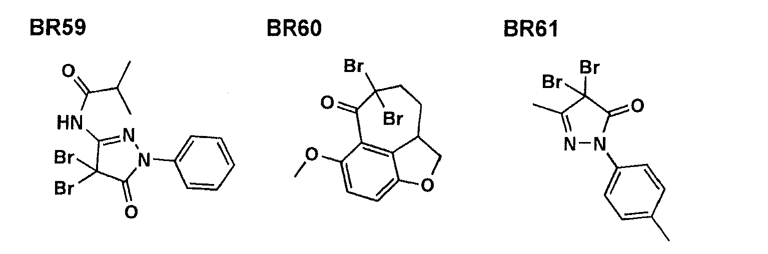

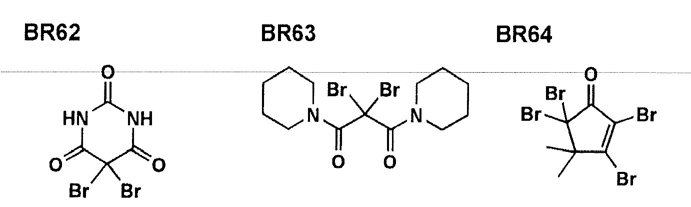

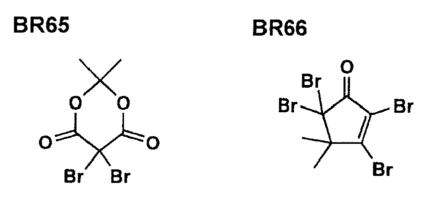

Another photopolymerizable initiator can be used in combination. Examples thereof include carbonyl compounds, organic sulfur compounds, peroxides, redox compounds, azo or diazo compounds, halides and photo-reducing dyes disclosed in J. Kosar, "Photosensitive Systems", Chapter 5, and those specific compounds are disclosed in British Patent No. 1,459,563.

Typical examples of the photopolymerizable initiator used in combination include the following compounds.

A benzoin derivative such as benzoin methyl ether, benzoin i-propyl ether, or α,α-dimethoxy-α-phenylacetophenone; a benzophenone derivative such as benzophenone, 2,4-dichlorobenzophenone, o-benzoyl methyl benzoate, or 4,4'-bis (dimethylamino) benzophenone; a thioxanthone derivative such as 2-chlorothioxanthone, 2-i-propylthioxanthone; an anthraquinone derivative such as 2-chloroanthraquinone or 2-methylanthraquinone; an acridone derivative such as N-methylacridone or N-butylacridone; α,α-diethoxyacetophenone; benzil; fluorenone; xanthone; an uranyl compound; a triazine derivative disclosed in Japanese Patent Publication Nos. 59-1281 and 61-9621 and Japanese Patent O.P.I. Publication No. 60-60104; an organic peroxide compound disclosed in Japanese Patent O.P.I. Publication Nos. 59-1504 and 61-243807; a diazonium compound in Japanese Patent Publication Nos. 43-23684, 44-6413, 47-1604 and US Patent No. 3,567,453; an organic azide compound disclosed in US Patent Nos. 2,848,328, 2,852,379 and 2,940,853; orthoquinondiazide compounds disclosed in Japanese Patent Publication Nos. 36-22062b, 37-13109, 38-18015 and 45-9610; various onium compounds disclosed in Japanese Patent Publication No. 55-39162, Japanese Patent O.P.I. Publication No. 59-14023 and "Macromolecules", Volume 10, p. 1307 (1977); azo compounds disclosed in Japanese Patent Publication No. 59-142205; metal arene complexes disclosed in Japanese Patent O.P.I. Publication No. 1-54440, European Patent Nos. 109,851 and 126,712, and "Journal of Imaging Science", Volume 30, p. 174 (1986); (oxo) sulfonium organoboron complexes disclosed in Japanese Patent O.P.I. Publication Nos. 5-213861 and 5-255347; titanocenes disclosed in Japanese Patent O.P.I. Publication Nos. 59-152396 and 61-151197; transition metal complexes containing a transition metal such as ruthenium disclosed in "Coordination Chemistry Review", Volume 84, p. 85-277 (1988) and Japanese Patent O.P.I. Publication No. 2-182701; 2,4,5-triarylimidazol dimmer disclosed in Japanese Patent O.P.I. Publication No. 3-209477; carbon tetrabromide; organic halide compounds disclosed in Japanese Patent O.P.I. Publication No. 59-107344.

The content of a photopolymerizable initiator of the present invention is preferably 0.1 - 20% by weight, with respect to the polymerizable ethylenic unsaturated bond-containing compound, but is more preferably 0.5 - 15% by weight.

### ((B) Binder)

The binder of the present invention is capable of carrying components in an image formation layer such as (A) a photopolymerizable initiator, (C) a polymerizable ethylenic unsaturated bond-containing compound, (D) a dye and so forth, and a polymeric binder is preferably usable.

Specifically, water-soluble polymers are preferably usable as the polymeric binder. The water-soluble polymer means a compound in which solubility with respect to water (the number of grams soluble in 100 g of water at 25 °C) is at least 0.1, and the molecular weight (weight average) is at least 500.

Examples of the water-soluble polymers in the present invention include a homopolymer or copolymer of polyvinyl alcohol, hydroxystyrene; a copolymer of polyamide, polyvinyl pyrrolidone or vinyl pyrrolidone; polyethylene oxide, polyethylene imine, polyacrylic amide, core starch, mannan, pectin, agar, dextran, pullulan, glue, hydroxymethylcellulose, alginic acid, carboxymethylcellulose, and sodium polyacrylate, which have various saponification degrees, for example.

Specifically, a polymeric compound having a nonionic hydrophilic group is preferably used as a water-soluble polymeric compound.

As the molecular weight, the weight average molecular weight is preferably 1,000 - 100,000, and more preferably 1,000 - 50,000.

A photosensitive layer of the present invention may contain a compound other than the water-soluble polymeric compound as a bonder, but a content of the water-soluble polymeric compound is preferably 80 - 100% by weight, based on the total weight of binder, and more preferably 90 - 100% by weight.

A content of the binder of the present invention is preferably 10 - 95% by weight, based on the weight of the photosensitive layer, and more preferably 30 - 90% by weight.

Examples of the binder usable in combination include a polyvinyl butyral resin, a polyester resin, an epoxy resin, a phenol resin, a polycarbonate resin, a polyvinyl butyral resin, polyvinyl formal resin, shellac and other natural resins.

### (Polymeric compound having nonionic hydrophilic group)

A nonionic hydrophilic group contained in a polymeric compound having the above-described nonionic hydrophilic group means a group or a bond exhibiting no ionization in water but hydrophilicity, and examples thereof include an alcoholic hydroxyl group, an aromatic hydroxyl group, an acid amide group, a sulfonamide group, a thiol group, a pyrrolidone group, a polyoxyethylene group, a polyoxypropylene group, a sugar residue and so forth.

As a polymeric compound having a nonionic hydrophilic group, a compound containing a nonionic hydrophilic group of at least 30% by weight is specifically preferable in view of developability.

A compound containing the above-described nonionic hydrophilic group is preferably an oligomer or a polymer having a weight average molecular weight of 1,000 - 50,000, and examples thereof include a polymer and a polyvinyl alcohol based polymer obtained by polymerizing at least one unsaturated monomer having the foregoing nonionic hydrophilic group in the side chain, and a cellulose based polymer and a glucose based polymer as polysaccharide.

Examples of the unsaturated monomer having an amide group in the side chain include unsubstituted or substituted (meth)acrylamide; an amidated monomer of a dibasic acid such as an itaconic acid, a fumaric acid or a maleic acid; N-vinylacetoamide; N-vinylformamide; N-vinylpyrrolidone and so forth.

Specific examples of unsubstituted or substituted (meth)acrylamide include (meth)acrylamide, N-methyl(meth)acrylamide, N,N-dimethyl(meth)acrylamide, N-ethyl(meth)acrylamide, N,N-diethyl(meth)acrylamide, N,N-dimethylaminopropyl(meth)acrylamide, N-isopropyl(meth)acrylamide, diacetone(meth)acrylamide, methylol(meth)acrylamide, methoxymethyl(meth)acrylamide, butoxymethyl(meth)acrylamide, sulfonic acid propyl(meth)acrylamide and (meth)acryloylmorpholine.

In the case of an amidated monomer of a dibasic acid such as the foregoing itaconic acid and so forth, monomide in which one carboxyl group is amidated may be allowed, diamide in which both carboxyl groups are amidated may also be allowed, and amideester in which one carboxyl group is amidated, and another carboxyl group is esterified may further be allowed.

Examples of the unsaturated monomer having a hydroxyl group include hydroxyethyl(meth)acrylate, hydroxypropyl(meth)acrylate, hydroxybutyl(meth)acrylate, a monomer in which ethyleneoxide or propyleneoxide is added into the (meth)acrylate thereof, methylol(meth)acrylamide, and methoxymethyl(meth)acrylamide and butoxymethyl(meth)acrylamide which are a condensation product of the methylol(meth)acrylamide with methyl alcohol or butyl alcohol.

The foregoing "(meth)acryl", "(meth)acrylate" and "(meth)acryloyl" mean acryl or methacryl, acrylate or meth acrylate, and acryloyl or methacryloyl, respectively.

A polyvinyl alcohol based polymer will further be described in detail. Examples thereof include a polymer obtained via complete or partial hydrolysis of a homopolymer or a copolymer of a fatty acid vinyl monomer such as vinyl acetate or propionic acid vinyl, and the foregoing polymer partially containing formal, acetal, butyral or such.

A compound containing a nonionic hydrophilic group of at least 30% by weight may possess a crosslinking functional group reacting with a crosslinking agent. As a specific example of the crosslinking functional group, a nonionic one is preferable, depending on kinds of the crosslinking agent, and examples thereof include a hydroxyl group, an isocyanate group, a glycidyl group, an oxazoline group and so forth.

In order to introduce these crosslinking functional groups, glycidyl(meth)acrylate as an unsaturated monomer having the functional group such as a unsaturated monomer having the foregoing hydroxyl group or a unsaturated monomer having the glycidyl group may be copolymerized with another (meth)acrylate monomer.

A compound containing a nonionic hydrophilic group of 30% by weight, which is other than an unsaturated monomer having the foregoing nonionic hydrophilic group and an unsaturated monomer having a crosslining functional group can polymerize the other copolymerizable unsaturated monomer in order to further produce the effect of the present invention.

Examples of other copolymerizable unsaturated monomers include methyl(meth)acrylate, ethyl(meth)acrylate, butyl(meth)acrylate, 2-ethylhexyl(meth)acrylate, glycidyl(meth)acrylate, methoxy(C1-C50)ethyleneglycol(meth)acrylate, dimethylaminoethyl(meth)acrylate, diethylaminoethyl(meth)acrylate, phenoxyethyl(meth)acrylate, benzyl(meth)acrylate, isopronyl(meth)acrylate, adamantyl(meth)acrylate, cyclohexyl(meth)acrylate, styrene, α-methylstyrene, acrylonitrile, methacrylonitrile, vinyl acetate and α-olefin (C4 - C30).

As a crosslinking agent used for crosslinking a compound containing a nonionic hydrophilic group of at least 30% by weight, crosslinking agents combined with a functional group described in "Crosslinking agent Handbook" (edited by T. Kaneko and S. Yamashita and published in 1981 by Taisei Co., Ltd.) can be selected.

Examples of the crosslinking agent include a hydroxyl group as a crosslinking functional group in a compound containing a nonionic hydrophilic group of at least 30% by weight; a glycidyl group; commonly known polyhydric alcohol compounds reacting with an amide group in some cases; polycarboxylic acid compounds and anhydrides thereof; polyglycidyl compounds (epoxy resins); polyamine compounds; polyamide resins; polyisocyanate compounds (including block isocianates); an oxazoline resin; an amino resin; glyoxal and so forth.

Among the foregoing crosslinking agents, preferable are commonly known various glycidyl compounds (epoxy resins), an oxazoline resin, an amono resin, a hardener for an epoxy resin such as a polyamine compound or a polyamide resin, and glyoxal in view of developability and printing suitability.

Examples of the amino resin include a commonly known melamine resin, a urea resin, a benzoguanamine resin, a glycoluril resin and modified resins thereof such as a carboxy modified melamine resin and so forth. Further, in order to accelerate crosslinking reaction, tertiary amines may be used in combination in the case of employing the foregoing glycidyl compound, and an acidic compound such as a p-toluenesulfonic acid, a dodecylbenzenesulfonic acid or an ammonium chloride may be used in combination in the case of employing an amino resin. The crosslinking agent is crosslinked to a compound containing a nonionic hydrophilic group of at least 30% by weight via reaction of the crosslinking agent by treating a photosensitive resin composition via warm heating, heated roller heating or laser heating.

Compounds containing at least 30% by weight of a nonionic hydrophilic group are as follows.
1. Vinyl pyrrolidone-vinyl acetate copolymer (60/40) weight average molecular weight of 34000 Product name: Luviskol 64 produced by BASF Japan, VP/VA = 60% by weight/40% by weight copolymer
2. Vinyl pyrrolidone-1·butene copolymer (90/10) weight average molecular weight of 17000 Product name: GANEX P-904 LC ISPchemicals
3. Vinyl pyrrolidone-glycidylmethacrylate copolymer (70/30) weight average molecular weight of 10000
4. Polyacrylamide weight average molecular weight of 1700 Product name: Acoflock N104 produced by Mitsui Chemicals AquaPolymer, Inc.

### ((C) Polymerizable ethylenic unsaturated bond-containing compound)

The polymerizable ethylenic unsaturated bond-containing compound is a compound having in the molecule a polymerizable ethylenic unsaturated bond, and polyfunctional monomers and oligomers having in the molecule plural addition-polymerizable ethylenic double bonds commonly usable for conventional radical polymerizable monomers and UV curable resins can be utilized.

The polymerizable ethylenic unsaturated monomer is not specifically limited. Examples thereof include a monofunctional acrylate such as 2-ethylhexyl acrylate, 2-hydroxypropyl acrylate, glycerol acrylate, tetrahydrofurfuryl acrylate, phenoxyethyl acrylate, nonylphenoxyethyl acrylate, tetrahydrofurfuryl-oxyethyl acrylate, tetrahydrofurfuryloxyhexanorideacrylate; a methacrylate, itaconate, crotonate or maleate alternative of the above acrylate; a bifunctional acrylate such as ethyleneglycol diacrylate, triethyleneglycol diacrylate, pentaerythritol diacrylate, hydroquinone diacrylate, resorcin diacrylate, hexanediol diacrylate, neopentyl glycol diacrylate, tripropylene glycol diacrylate, hydroxypivalic acid neopentyl glycol diacrylate, neopentyl glycol adipate diacrylate, diacrylate of hydroxypivalic acid neopentyl glycol-ε-caprolactone adduct, 2-(2-hydroxy-1,1-dimethylethyl)-5-hydroxymethyl-5-ethyl-1,3-dioxane diacrylate, tricyclodecanedimethylol acrylate, tricyclodecanedimethylol acrylate-ε-caprolactone adduct or 1,6-hexanediol diglycidylether diacrylate; a dimethacrylate, diitaconate, dicrotonate or dimaleate alternative of the above diacrylate; a polyfunctional acrylate such as trimethylolpropane triacrylate, ditrimethylolpropane tetraacrylate, trimethylolethane triacrylate, pentaerythritol triacrylate, pentaerythritol tetraacrylate, dipentaerythritol tetraacrylate, dipentaerythritol pentaacrylate, dipentaerythritol hexacrylate, dipentaerythritol hexacrylate-ε-caprolactone adduct, pyrrogallol triacrylate, propionic acid dipentaerythritol triacrylate, propionic acid dipentaerythritol tetraacrylate or hydroxypivalylaldehyde modified dimethylolpropane triacrylate; and a methacrylate, itaconate, crotonate or maleate alternative of the above polyfunctional acrylate.

### (Polymerizable ethylenic unsaturated bond-containing compound containing a light oxidizable group)

The polymerizable ethylenic unsaturated bond-containing compound in an image formation layer of the present invention is preferably a polymerizable ethylenic unsaturated bond-containing compound containing at least a light oxidizable group.

An addition-polymerizable compound containing both a light oxidizable group and a urethane group is especially preferred. Examples of the light oxidizable group include a thio group, thioether group, a ureido group, an amino group, and an enol group, each of which may be a member constituting heterocycles. As moieties containing these groups, there are, for example, a triethanolamino moiety, a triphenylamino moiety, a thioureide moiety an imidazolyl moiety, an oxazolyl moiety, a thiazolyl moiety, an acetylacetonyl moiety, an N-phenylglycine moiety, and an ascorbic acid moiety. Preferred is an addition-polymerizable compound containing a tertiary amino group or a thioether group.

Exemplified compounds containing a light oxidizable group are listed in European Patent Publication Nos. 287,818, 353,389 and 364,735. Among the exemplified compounds, compounds containing a tertiary amino group, and a ureido group and/or a urethane group are preferred.

Examples of the compound containing both a light oxidizable group and a urethane group are listed in Japanese Patent Publication No. 2669849, and Japanese Patent O.P.I. Publication Nos. 63-260909, 6-35189, and 2001-125255.

Further, in the present invention, preferably employed is a reaction product of a polyhydric alcohol containing a tertiary amino group in the molecule, a diisocyanate compound, and a compound having a hydroxyl group and an addition polymerizable ethylenic double bond-containing compound in the molecule.

Examples of the polyhydric alcohol containing a tertiary amino group in the molecule include triethanolamine, N-methyldiethanolamine, N-ethyldiethanolamine, N-ethyldiethanolamine, N-n-butyldiethanolamine, N-tert-butyldiethanolamine, N,N-di(hydroxyethyl)aniline, N,N, N', N'-tetra-2-hydroxypropylethylenediamine, p-tolyldiethanolamine, N,N, N', N'-tetra-2-hydroxyethylethylenediamine, N,N-bis(2-hydroxypropyl)aniline, allyldiethanolamine, 3-dimethylamino-1,2-propane diol, 3-diethylamino-1,2-propane diol, N,N-di(n-propylamino)-2,3-propane diol, N,N-di(iso-propylamino)-2,3-propane diol, and 3-(N-methyl-N-benzylamino)-1,2-propane diol, but the present invention is not specifically limited thereto.

Examples of the diisocyanate compound include butane-1,4-diisocyanate, hexane-1,6-diisocyanate, 2-methylpentane-1,5-diisocyanate, octane-1,8-diisocyanate, 1,3-diisocyanatomethylcyclohexanone, 2,2,4-trimethylhexane-1,6-diisocyanate, isophorone diisocyanate, 1,2-phenylene diisocyanate, 1,3-phenylene diisocyanate, 1,4-phenylene diisocyanate, tolylene-2,4-diisocyanate, tolylene-2,5-diisocyanate, tolylene-2,6-diisocyanate, 1,3-di(isocyanatomethyl)benzene, and 1,3-bis(1-isocyanato-1-methylethyl)benzene, but the invention is not specifically limited thereto. Examples of the compound having a hydroxyl group and an addition polymerizable ethylenic double bond in the molecule is not specifically limited, but 2-hydroxyethyl methacrylate, 2-hydroxyethyl acrylate, 4-hydroxybutyl acrylate, 2-hydroxypropylene-1,3-dimethacrylate, and 2-hydroxypropylene-1-methacrylate-3-acrylate are preferred.

The reaction product can be synthesized according to the same method as a conventional method in which urethaneacrylate is ordinarily synthesized employing a diol compound, a diisocyanate compound and an acrylate compound having a hydroxyl group.

Specific examples of the reaction product of a polyhydric alcohol containing a tertiary amino group in the molecule, a diisocyanate compound, and a compound having a hydroxyl group and an addition polymerizable ethylenic double bond-containing compound in the molecule are shown below.
M-1: A reaction product of triethanolamine (1 mole), hexane-1,6-diisocyanate (3 moles), and 2-hydroxyethyl methacrylate (3 moles)
M-2: A reaction product of triethanolamine (1 mole), isophorone diisocyanate (3 moles), and 2-hydroxyethyl methacrylate (3 moles)
M-3: A reaction product of N-n-butyldiethanolamine (1 mole), 1,3-bis(1-cyanato-1-methylethyl)benzene (2 moles), and 2-hydroxypropylene-1-methacrylate-3-acrylate (2 moles)
M-4: A reaction product of N-n-butyldiethanolamine (1 mole), 1,3-di(cyanatomethyl)benzene (2 moles), and 2-hydroxypropylene-1-methacrylate-3-acrylate (2 moles)
M-5: A reaction product of N-methydiethanolamine (1 mole), tolylene-2,4-diisocyanate (2 moles), and 2-hydroxypropylene-1,3-dimethacrylate (2 moles)

### (Other polymerizable ethylenic unsaturated bond-containing compounds)

Prepolymers are also usable as polymerizable ethylenic unsaturated bond-containing compounds in the same manner as described above.

A prepolymer can be used, and examples of the prepolymer include compounds as described later. The prepolymer with a photopolymerizable property, which is obtained by incorporating acrylic acid or methacrylic acid in oligomer with an appropriate molecular weight, can be suitably employed.

This prepolymer can be used singly, as an admixture of the above described monomers and/or oligomers.

Examples of the prepolymer include polyester (meth)acrylate obtained by incorporating (meth)acrylic acid in a polyester of a polybasic acid such as adipic acid, trimellitic acid, maleic acid, phthalic acid, terephthalic acid, hymic acid, malonic acid, succinic acid, glutaric acid, itaconic acid, pyromellitic acid, fumalic acid, pimelic acid, sebatic acid, dodecanic acid or tetrahydrophthalic acid with a polyol such as ethylene glycol, ethylene glycol, diethylene glycol, propylene oxide, 1,4-butane diol, triethylene glycol, tetraethylene glycol, polyethylene glycol, grycerin, trimethylol propane, pentaerythritol, sorbitol, 1,6-hexanediol or 1,2,6-hexanetriol; an epoxyacrylate such as bisphenol A·epichlorhydrin·(meth)acrylic acid or phenol novolak·epichlorhydrin·(meth)acrylic acid obtained by incorporating (meth)acrylic acid in an epoxy resin; an urethaneacrylate such as ethylene glycol·adipic acid·tolylenediisocyanate·2-hydroxyethylacrylate, polyethylene glycol·tolylenediisocyanate·2-hydroxyethylacrylate, hydroxyethylphthalyl methacrylate·xylenediisocyanate, 1,2-polybutadieneglycol·tolylenediisocyanate·2-hydroxyethylacrylate or trimethylolpropane·propylene glycol·tolylenediisocyanate·2-hydroxyethylacrylate, obtained by incorporating (meth)acrylic acid in an urethane resin; a silicone acrylate such as polysiloxane acrylate, or polysiloxane-diisocyanate-2-hydroxyethylacrylate; an alkyd modified acrylate obtained by incorporating a methacroyl group in an oil modified alkyd resin; and a spiran resin acrylate.

As the polymerizable ethylenic unsaturated bond-containing compound of the present invention, there are a monomer such as a phosphazene monomer/triethylene glycol/EO (ethyleneoxide) modified isocyanuric acid diacrylate, an EO modified isocyanuric acid triacrylate, dimethyloltricyclodecane diacrylate, trimethylolpropane acrylate benzoate, an alkylene glycol acrylate, or a urethane modified acrylate, or an addition-polymerizable oligomer or prepolymer having a structural unit derived from the above monomer.

Besides the above compounds, compounds disclosed in Japanese Patent O.P.I. Publication Nos. 58-212994, 61-6649, 62-46688, 62-48589, 62-173295, 62-187092, 63-67189, and 1-244891, compounds described on pages 286 to 294 of "11290 Chemical Compounds" edited by Kagakukogyo Nipposha, and compounds described on pages 11 to 65 of "UV·EB Koka Handbook (Materials)" edited by Kobunshi Kankokai can be suitably used.

In the present invention, the content of the polymerizable ethylenic unsaturated bond-containing compound described above in an image formation layer is preferably 1.0 - 80.0% by weight with respect to the image formation layer, and more preferably 3.0 - 70.0% by weight.

### ((D) Dye exhibiting maximum absorption in the wavelength range of 350 - 450 nm)

As dyes exhibiting maximum absorption in the wavelength range of 350 - 450 nm, which are compounds represented by the following Formula (1), there are, for example, cumarin derivatives B-1 through B-22 disclosed in Japanese Patent O.P.I. Publication No. 8-129258, cumarin derivatives D-1 through D-32 disclosed in Japanese Patent O.P.I. Publication No. 2003-121901, cumarin derivatives 1 through 21 disclosed in Japanese Patent O.P.I. Publication No. 2002-363206, cumarin derivatives 1 through 40 disclosed in Japanese Patent O.P.I. Publication No. 2002-363207, cumarin derivatives 1 through 34 disclosed in Japanese Patent O.P.I. Publication No. 2002-363208, and cumarin derivatives 1 through 56 disclosed in Japanese Patent O.P.I. Publication No. 2002-363209. Examples of compounds represented by Formula (1) are shown below.

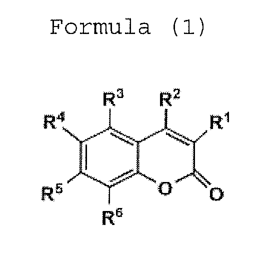

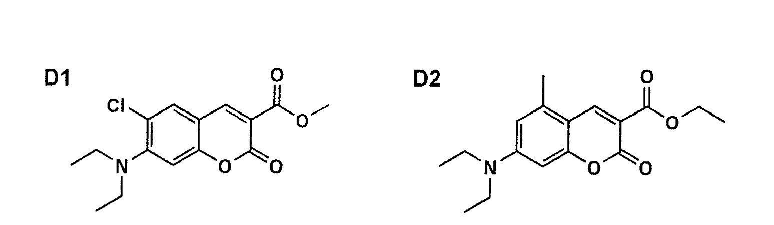

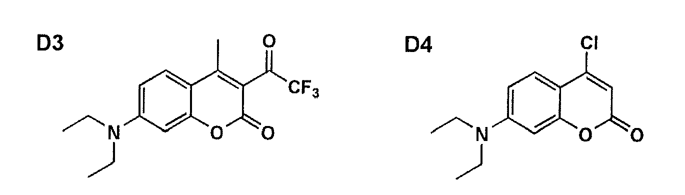

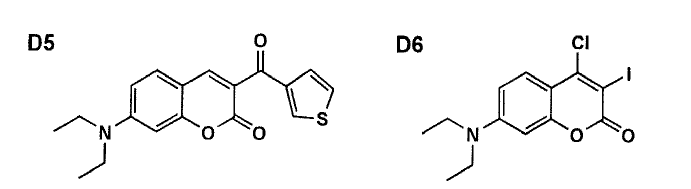

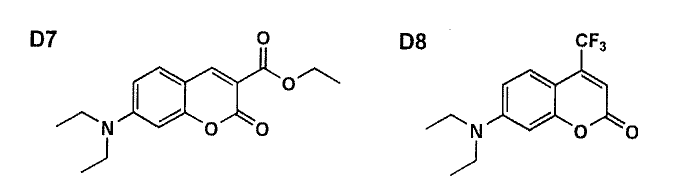

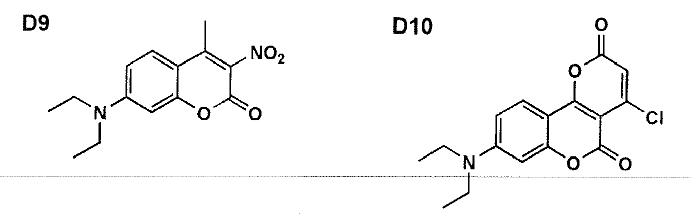

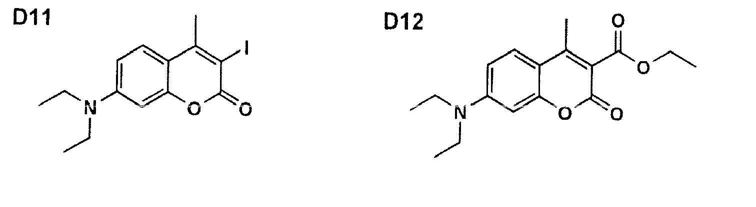

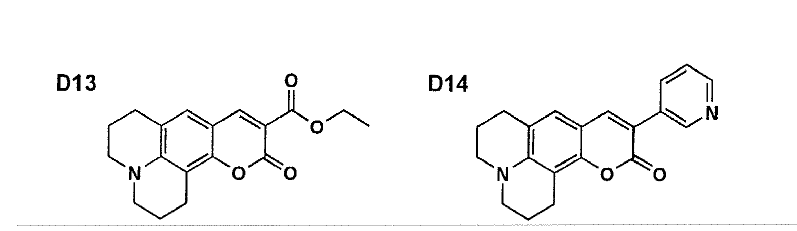

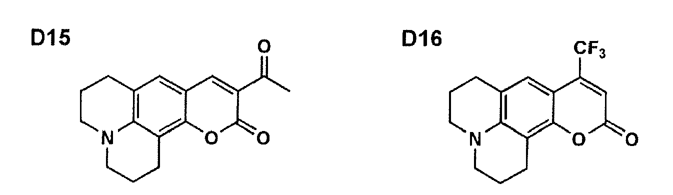

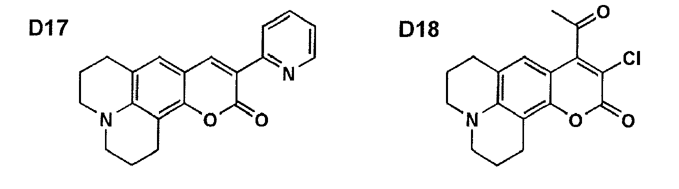

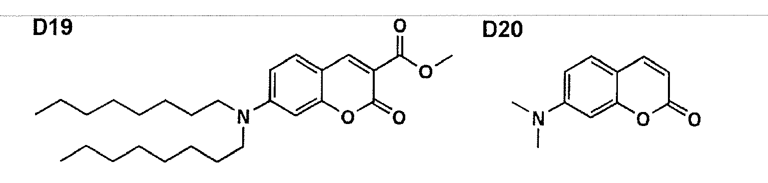

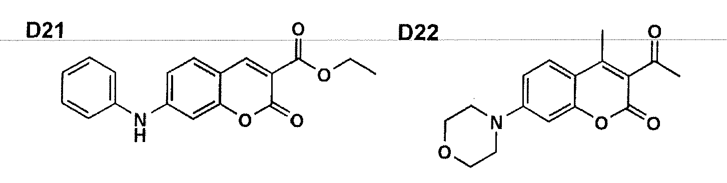

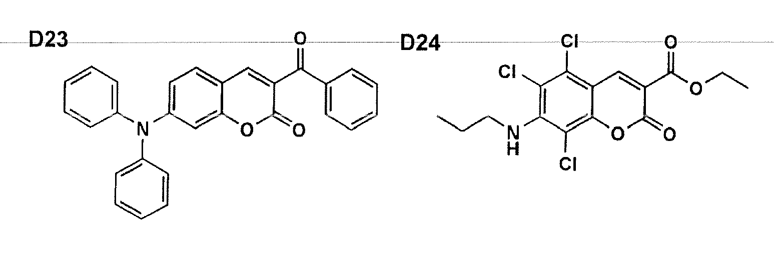

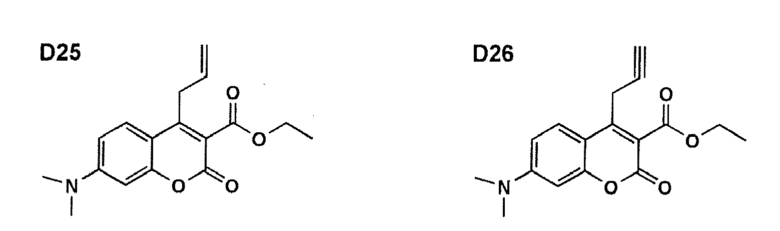

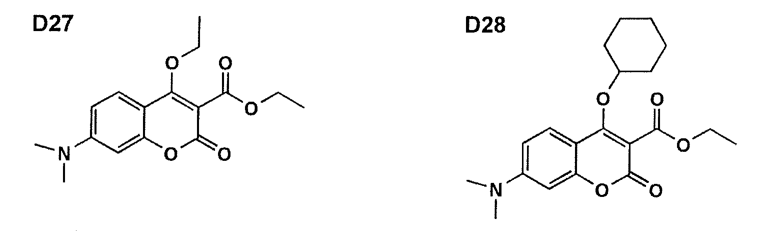

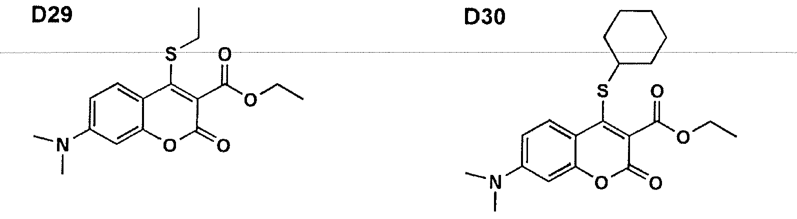

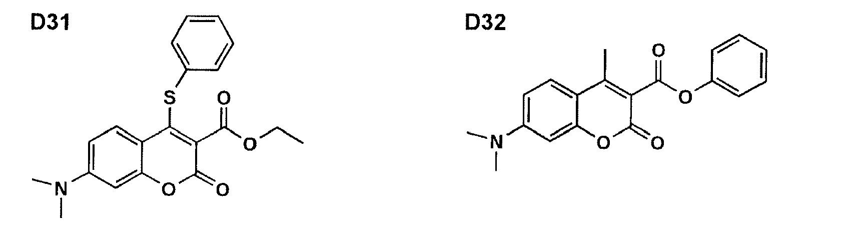

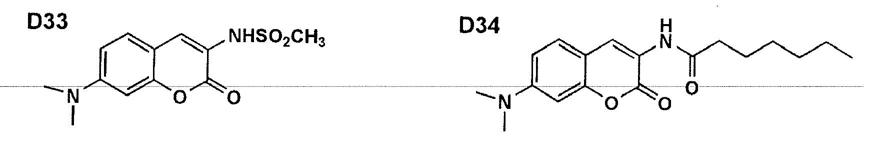

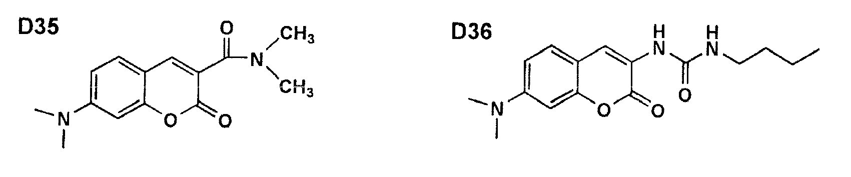

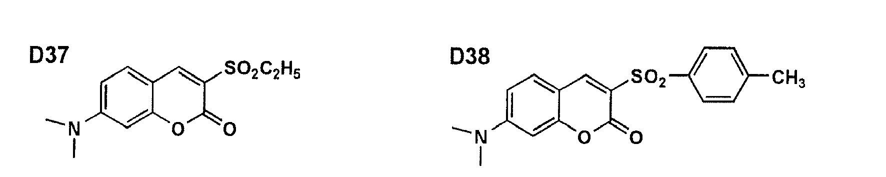

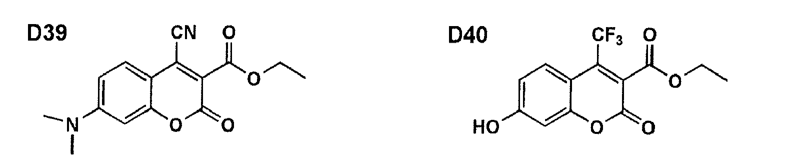

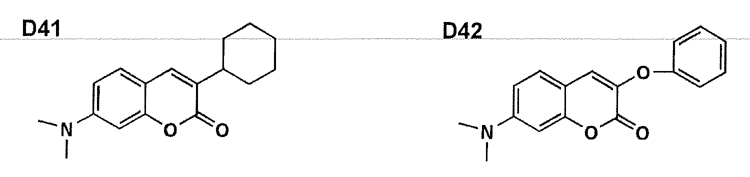

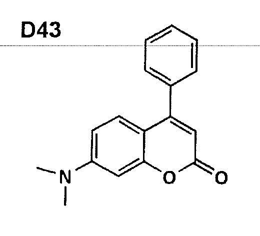

Further, examples of other sensitizing dyes include sensitizing dyes disclosed in Japanese Patent O.P.I. Publication Nos. 2000-98605, 2000-147763, 2000-206690, 2000-258910, 2000-309724, 2001-04254, 2002-202598, 2000-221790, 2003-206307 and 2003-221517.

### (Light-to-heat conversion material)

The image formation layer of the present invention preferably contains a light-to-heat conversion material in view of printing durability.

The light-to-heat conversion material is capable of generating heat upon exposure to laser light having a wavelength of 700 - 1500 nm. As the light-to-heat conversion material, the following Light-to-heat conversion dyes and other light-to-heat conversion materials are employed.

### [Light-to-heat conversion dye]

The following light-to-heat conversion dyes are usable.

Examples of the infrared absorbing dye include a conventional infrared absorbing dye such as a cyanine dye, a chloconium dye, a polymethine dye, an azulenium dye, a squalenium dye, a thiopyrylium dye, a naphthoquinone dye or an anthraquinone dye, and an organometallic complex such as a phthalocyanine compound, a naphthalocyanine compound, an azo compound, a thioamide compound, a dithiol compound or an indoaniline compound. Specifically, the materials include compounds disclosed in Japanese Patent O.P.I. Publication Nos. 63-139191, 64-33547, 1-160683, 1-280750, 1-293342, 2-2074, 3-26593, 3-30991, 3-34891, 3-36093, 3-36094, 3-36095, 3-42281, 3-97589 and 3-103476. These compounds may be used singly or in combination.

Compounds described in Japanese Patent O.P.I. Publication Nos. 11-240270, 11-265062, 2000-309174, 2002-49147, 2001-162965, 2002-144750, and 2001-219667 can be preferably used.

### [Other light-to-heat conversion materials]

In addition to the above-described light-to-heat conversion dyes, other light-to-heat conversion materials can be used in combination.

Preferable examples of the light-to-heat conversion material include carbon, graphite, metal and metal oxide.

Furnace black and acetylene black is preferably used as the carbon. The graininess (d₅₀) thereof is preferably at most 100 nm, and more preferably at most 50 nm.

Particles having an average particle diameter of preferably at most 0.5 µm, more preferably at most 100 nm, and most preferably at most 50 nm are usable as the graphite.

As the metal, any metal can be used as long as the metal is in a form of fine particles having preferably an average particle diameter of at most 0.5 µm, more preferably at most 100 nm, and most preferably at most 50 nm. The metal may have any shape such as spherical, flaky and needle-like. Colloidal metal particles such as those of silver or gold are particularly preferred.

As the metal oxide, materials having black color in the visible regions or materials which are electrically conductive or semi-conductive can be used.

Examples of the former include black iron oxide (Fe₃O₄) and black complex metal oxides containing at least two metals.

Examples of the latter include Sb-doped SnO₂ (ATO), Sn-added In₂O₃ (ITO), TiO₂, TiO prepared by reducing TiO₂ (titanium oxide nitride, generally titanium black).

### (Various additives)

A hindered phenol compound, a hindered amine compound or other polymerization inhibitors in addition to the compounds described above may be added into an image formation layer of the present invention, in order to prevent undesired polymerization of the ethylenic unsaturated double bond-containing compound during manufacture or storage of the photosensitive planographic printing plate material.

Examples of the hindered phenol compound include 2,6-di-t-butyl-p-cresol, butylhydroxyanisole, 2,2'-methylenebis(4-methyl-6-t-butylphenol), 4,4'-butylidenebis(3-methyl-6-t-butylphenol) tetrakis[methylene-3-(3',5'-t-butyl-4'-hydroxyphenyl)- propionate] methane, bis[3,3'-bis(4'-hydroxy-3'-t-butylphenyl) butyric acid] glycol ester, 2-t-butyl-6-(3-t-butyl-2-hydroy-5-methylbenzyl)-4-methylphenyl acrylate, and 2-[1-(2-hydroxy-3,5-di-t-pentylphenyl)ethyl]-4,6-di-t-pentylphenyl acrylate. Among them, 2-t-butyl-6-(3-t-butyl-2-hydroy-5-methylbenzyl)- 4-methylphenyl acrylate and 2-[1-(2-hydroxy-3,5-di-t-pentylphenyl)ethyl]-4,6-di-t-pentylphenyl acrylate, each having a (meth)acryloyl group, are preferred.

Examples of the hindered amine compound include bis(1,2,2,6,6-pentamethyl-4-piperidyl)sebacate, bis(2,2,6,6-tetramethyl-4-piperidyl)sebacate, 1-[2-{3-(3,5-di-t-butylhydroxyphenyl)propionyloxy}ethyl]-4-[2-{3-(3,5-di-t-butylhydroxyphenyl)propionyloxy}ethyl]-2,2,6,6-tetramethylpiperidine, 4-benzoyloxy-2,2,6,6-tetramethylpiperidine, and 8-acetyl-3-dodecyl-7,7,9,9-tetramethyl-1,3,8-triazaspiro-[4. 5]decane-2,4-dione.

Examples of other polymerization inhibitors include hydroquinone, p-methoxyphenol, di-t-butyl-p-cresol, pyrrogallol, t-butylcatechol, benzoquinone, 4,4'-thiobis (3-methyl-6-t-butylphenol), 2,2'-methylenebis (4-methyl-6-t-butylphenol), N-nitrosophenylhydroxylamine cerous salt, and hindered amines such as 2,2,6,6-tetramethylpiperidine derivatives-butyl-6-(3-t-butyl-6-hydroxy-5-mrthylbenzyl)-4-methylphenyl acrylate.

The polymerization inhibitor content is preferably 0.01 - 5% by weight based on the weight of the image formation layer. Further, in order to prevent polymerization induced by oxygen, a higher fatty acid such as behenic acid or a higher fatty acid derivative such as behenic amide may be added to the image formation layer, or may be localized on the surface of the image formation layer in the course of drying after coating. The higher fatty acid or higher fatty acid derivative content is preferably 0.5 - 10% by weight based on the total compositions.

A colorant other than the above-described components can be used for the image formation layer of the present invention. As the colorant can be used known materials including commercially available materials. Examples of the colorant include those described in revised edition "Ganryo Binran", edited by Nippon Ganryo Gijutu Kyoukai (published by Seibundou Sinkosha), or "Color Index Binran".

Kinds of the pigment include black pigment, yellow pigment, red pigment, brown pigment, violet pigment, blue pigment, green pigment, fluorescent pigment, and metal powder pigment. Examples of the pigment include inorganic pigment (such as titanium dioxide, carbon black, graphite, zinc oxide, Prussian blue, cadmium sulfide, iron oxide, or chromate of lead, zinc, barium or calcium); and organic pigment (such as azo pigment, thioindigo pigment, anthraquinone pigment, anthanthrone pigment, triphenedioxazine pigment, vat dye pigment, phthalocyanine pigment or its derivative, or quinacridone pigment).

Among these pigment, pigment is preferably used which does not substantially have absorption in the absorption wavelength regions of a spectral sensitizing dye used according to a laser for exposure. The absorption of the pigment used is at most 0.05, obtained from the reflection spectrum of the pigment measured employing an integrating sphere and employing light with the wavelength of the laser used.

An addition amount of the pigment is preferably 0.1 - 10% by weight based on the solid content of the image formation layer, and more preferably 0.2 - 5% by weight.

A plasticizer can also be contained in the image formation layer in order to improve adhesion to the support.

Examples of the plasticizer include dimethyl phthalate, diethyl phthalate, dibutyl phthalate, diheptyl phthalate, di-2-ethylhexyl phthalate, di-n-octyl phthalate, didodecyl phthalate, diisodecyl phthalate, butylbenzyl phthalate, diisononyl phthalate, didodecyl phthalate, ethylphthalyl ethyl glycol, dimethyl isophthalate, triethylene glycol dicaprylate, dimethyl glycol phthalate, tricresyl phosphate, dioctyl adipate, dibutyl sebacate, and triacetyl glycerin. The plasticizer content of the image formation layer is preferably approximately 0 - 3% by weight, based on the total solid content of the above-described composition, and more preferably 0.1 - 2% by weight.

A coatability improving agent such as a surfactant employed for coating an image formation layer can also be contained as long as performance of the present invention is not deteriorated. Of these, a fluorine based surfactant is preferable.

Additives such as inorganic fillers or a plasticizer such as dioctyl phthalate, dimethyl phthalate or tricresyl phosphate may be added to improve a physical property of the image formation layer. The addition amount thereof is preferably at most 10% by weight based on the total solid content of the image formation layer.

### (Protective layer)

A protective layer is preferably provided on the image formation layer of the present invention. It is preferred that the protective layer (oxygen shielding layer) is highly soluble in dampening water employed for planographic printing.

In the present invention, a protective layer containing the foregoing light-to-heat conversion material is also usable in view of printing durability and image reproduction.

The foregoing light-to-heat conversion material is used as a foregoing light-to-heat conversion material.

The content of the light-to-heat conversion material in the protective layer is preferably 0.5 - 90% by weight, and more preferably 1 - 70% by weight.

Materials constituting the protective layer are preferably polyvinyl alcohol, polysaccharide, polyvinyl pyrrolidone, polyethylene glycol, gelatin, glue, casein, hydroxyethyl cellulose, carboxymethyl cellulose, methyl cellulose, hydroxyethyl starch, gum arabic, sucrose octacetate, ammonium alginate, sodium alginate, polyvinyl amine, polyethylene oxide, polystyrene sulfonic acid, polyacrylic acid, or a water soluble polyamide. These materials may be used alone or in combination. Especially preferred material is polyvinyl alcohol.

A coating composition for the protective layer is obtained by dissolving the materials described above in a solvent. The coating liquid is coated on the photopolymerizable image formation layer and dried to form a protective layer. The thickness of the protective layer is preferably 0.1 - 5.0 µm, and more preferably 0.5 - 3.0 µm. The protective layer may contain a surfactant or a matting agent, if desired.

The coating method as described above in coating of the image formation layer coating liquid applies in the protective layer coating method. The drying temperature of the protective layer is preferably lower than that of the image formation layer. The former is preferably at least 10 °C lower than that of the latter, and more preferably at least 20 °C lower than that of the latter. The upper limit is approximately 50 °C.

Further, the drying temperature of the protective layer is preferably lower than glass transition temperature (Tg) of the binder contained in the image formation layer. The drying temperature of the protective layer is preferably at least 20 °C lower than Tg of the binder contained in the image formation layer, and more preferably at least 40 °C lower than Tg of the binder contained in the image formation layer. The upper limit is approximately 60 °C.

### (Coating)

The image formation layer coating liquid is prepared, and this liquid is coated on a support and dried to obtain an image formation layer of the present invention.

The solvents employed during coating include an alcohol such as sec-butanol, isobutanol, n-hexanol, or benzyl alcohol; a polyhydric alcohol such as diethylene glycol, triethylene glycol, tetraethylene glycol, or 1,5-pentanediol; an ether such as propylene glycol monobutyl ether, dipropylene glycol monomethyl ether, or tripropylene glycol monomethyl ether; a ketone or aldehyde such as diacetone alcohol, cyclohexanone, or methyl cyclohexanone; and an ester such as ethyl lactate, butyl lactate, diethyl oxalate, or methyl benzoate.

Examples of the coating method with a coating liquid include an air doctor coating method, a blade coating method, a wire bar coating method, a knife coating method, a dip coating method, a reverse roll coating method, a gravure coating method, a cast coating method, a curtain coating method, and an extrusion coating method.

### (Support)

The support of the present invention is a plate or film sheet capable of carrying the image formation layer, and preferably has a hydrophilic surface on the image formation layer side.

Examples of the support include a plate of a metal such as aluminum, stainless steel, chromium, or nickel, a plastic film such as a polyester film, a polyethylene film or a polypropylene film which is deposited or laminated with the above-described metal.

A polyester film, a polyvinyl chloride film or a nylon film as a support and provided thereon, a hydrophilic layer are usable, but in the present invention, an aluminum support is preferably used specifically in view of printing durability. An aluminum support subjected to the after-mentioned surface-roughened treatment and anodizing treatment is preferably used.

As the aluminum support, used is a pure aluminum plate or an aluminum alloy plate.

As the aluminum alloy, there can be used various ones including an alloy of aluminum and a metal such as silicon, copper, manganese, magnesium, chromium, zinc, lead, bismuth, nickel, titanium, sodium or iron. As the aluminum support, a surface-roughened aluminum support is used in order to give a water holding property.

It is preferable that the support in the invention is subjected to degreasing treatment for removing rolling oil prior to surface roughening (graining). The degreasing treatments include degreasing treatment employing solvents such as trichlene and thinner, and an emulsion degreasing treatment employing an emulsion such as kerosene or triethanol. It is also possible to use an aqueous alkali solution such as caustic soda for the degreasing treatment. When an aqueous alkali solution such as caustic soda is used for the degreasing treatment, it is possible to remove soils and an oxidized film which can not be removed by the above-mentioned degreasing treatment alone. When an aqueous alkali solution such as caustic soda is used for the degreasing treatment, the resulting support is preferably subjected to desmut treatment in an aqueous solution of an acid such as phosphoric acid, nitric acid, sulfuric acid, chromic acid, or a mixture thereof, since smut is produced on the surface of the support. The surface roughening methods include a mechanical surface roughening method and an electrolytic surface roughening method electrolytically etching the support surface.

Though there is no restriction for the mechanical surface roughening method, a brushing roughening method and a honing roughening method are preferable.

Though there is no restriction for the electrolytic surface roughening method, a method in which the support is electrolytically surface roughened in an acidic electrolytic solution.

After the support has been electrolytically surface roughened, it is preferably dipped in an acid or an aqueous alkali solution in order to remove aluminum dust, etc. produced in the surface of the support. Examples of the acid include sulfuric acid, persulfuric acid, hydrofluoric acid, phosphoric acid, nitric acid and hydrochloric acid, and examples of the alkali include sodium hydroxide and potassium hydroxide. Among those mentioned above, the aqueous alkali solution is preferably used. The dissolution amount of aluminum in the support surface is preferably 0.5 - 5 g/m². After the support has been dipped in the aqueous alkali solution, it is preferable for the support to be dipped in an acid such as phosphoric acid, nitric acid, sulfuric acid and chromic acid, or in a mixed acid thereof, for neutralization.

The mechanical surface roughening and electrolytic surface roughening may be carried out singly, and the mechanical surface roughening followed by the electrolytic surface roughening may be carried out.

After the surface roughening, anodizing treatment may be carried out. There is no restriction in particular for the method of anodizing treatment used in the invention, and known methods can be used. The anodizing treatment forms an anodization film on the surface of the support.

The support which has been subjected to anodizing treatment is optionally subjected to sealing treatment. For the sealing treatment, it is possible to use known methods using hot water, boiling water, steam, a sodium silicate solution, an aqueous dicromate solution, a nitrite solution and an ammonium acetate solution.

After the above treatment, the support is suitably undercoated with a water soluble resin such as polyvinyl phosphonic acid, a polymer or copolymer having a sulfonic acid in the side chain, or polyacrylic acid; a water soluble metal salt such as zinc borate; a yellow dye, an amine salt; and so on. The sol-gel treatment support, which has a functional group capable of causing addition reaction by radicals as a covalent bond, is suitably used.

### (Plate-making method)

### (On-press development method)

In a plate-making method of the present invention, an imagewise exposed planographic printing plate material is subjected to a development treatment on a printing press with dampening water and/or printing ink without conducting particularly a wet treatment process after image exposure to form images for printing. Then, printing is continuously carried out.

The imagewise exposure may be conducted before mounting a planographic printing plate material on a printing press, and the imagewise exposure may be conducted after mounting it continuously to conduct on-press development, but in the present invention, the imagewise exposure is preferably conducted on a printing press in view of image reproduction.

A development treatment conducted on a planographic printing press of the present invention means that non-image portions are removed on a printing press with dampening water and/or printing press for a planographic printing at a preparation stage for printing, and a so-called development process is conducted on the printing press.

Removal (on-press development) of the non-image portions (unexposed portions) of the image formation layer of a printing plate material mounted on the plate cylinder, can be carried out by bringing a dampening roller and an inking roller into contact with the image formation layer while rotating the plate cylinder. On-press development can be carried out, for example by various sequences as described below or another appropriate sequence. The supplied amount of dampening solution may be adjusted to be greater or smaller than the amount ordinarily supplied in printing, and the adjustment may be carried out stepwise or continuously.

Sequence (1) A dampening roller is brought into contact with the image formation layer of a printing plate material on the plate cylinder during one to several tens of rotations of the plate cylinder, and then an inking roller brought into contact with the image formation layer during the next one to tens of rotations of the plate cylinder. Thereafter, printing is carried out.

Sequence (2) An inking roller is brought into contact with the image formation layer of a printing plate material on the plate cylinder during one to several tens of rotations of the plate cylinder, and then a dampening roller brought into contact with the image formation layer during the next one to tens of rotations of the plate cylinder. Thereafter, printing is carried out.

Sequence (3) An inking roller and a dampening roller are brought into contact with the image formation layer of a printing plate material on the plate cylinder during one to several tens of rotations of the plate cylinder. Thereafter, printing starts.

Generally, a commonly known planographic offset printing press is used as a printing press.

Dampening water generally applied for printing a planographic printing plate is usable as the dampening water. Only water is allowed to be used, or additives may also be contained.

The dampening water containing no isopropanol which has been conventionally used is preferably used as dampening water. In this case, "containing no isopropanol" means the content of less than 0.5% by weight.

A solution containing a surfactant is preferably used as the dampening water.

Conventionally usable dampening water such as tap water, well water or so forth can be utilized.

As a slight amount of component, contained in the dampening water may be acids such as a phosphoric acid or its salt, a citric acid or its salt, a nitric acid or its salt, and an acetic acid or its salt, for example. Specifically, also contained may be acids such as a phosphoric acid, an ammonium phosphoric acid, a sodium phosphoric acid, a citric acid, an ammonium citric acid, a sodium citric acid, an acetic acid, an ammonium acetic acid and a sodium acetic acid. Water-soluble polymeric compounds such as carboxy methyl cellulose, carboxy ethyl cellulose and so forth may also be contained.

The content of the slight amount of component is less than 0.1% by weight, and preferably less than 0.05% by weight.

Further, examples of glycol based compounds include propylene glycol monomethylether, propylene glycol monoethylether, propylene glycol monobutylether, propylene glycol propylether, propylene glycol dimethylether, propylene glycol diethylether, propylene glycol dibutylether, dipropylene glycol dimethylether, dipropylene glycol diethylether, dipropylene glycol dibutylether and so forth. The content of the glycol based compound is preferably a small amount of less than 0.1% by weight, and more preferably less than 0.05% by weight.

A surfactant may also be contained.

A nonionic surfactant, an anionic surfactant, a cationic surfactant or a surfactant obtained by mixing these surfactants are preferably used as the surfactant.

These surfactants may be used singly or in combination with at least two kinds. The amount of surfactant in dampening water is preferably at most 0.01% by weight, and more preferably at most 0.05% by weight.

### (Printing)

A planographic printing plate prepared via a plate-making method of the present invention is subjected to planographic printing, but a conventional planographic offset printing press in which dampening water is utilized as described above is usable as a printing press.

Printing paper, printing ink, dampening water and so forth which are used for printing are not specifically limited.

In recent years, printing ink containing no petroleum volatile organic compound (VOC) has been developed and used in view of environmental concern. The present invention provides excellent effects in employing such an environmental printing ink.

As the ink, ink containing soybean oil is preferable.

Generally, the ink containing soybean oil is one mixed with an organic pigment, an inorganic pigment, a binder resin, soybean oil or a high boiling point petroleum solvent, and may also contain a plasticizer, a stabilizer, a desiccant agent, a thickner, a dispersant, a filler or such as an auxiliary substance.

As ink preferably usable for planographic printing, ink accredited via the soy seal recognition system by American Soybean Association (ASA) is provided.

Commonly known soybean oil is usable as the soybean oil, and soybean oil for food (purified soybean oil) accredited by Japan Agricultural Standards is preferably employed.

The ink containing soybean oil is sold by various ink manufacturers, and easily purchased. Examples thereof include Naturalith 100 sheet-fed printing ink and WebWorldAdvan web offset printing ink (produced by Dainippon Ink and Chemicals, Inc.), TK Hyunity SOY sheet-fed printing ink, TK HyEcho-SOY sheet-fed printing ink, CK WINECO-SOY sheet-fed printing ink, WD Super LeoEcoo-SOY web offset printing ink, WD LeoEcoo-SOY web offset printing ink and SCRSOY Business Form ink (produced by Toyo Ink MFG. Co., Ltd.), and Soycelvo sheet-fed printing ink (produced by Tokyo Printing Ink MFG. Co., Ltd.).

### EXAMPLE

Next, the present invention will be explained below employing examples, but embodiments of the present invention are not limited thereto. In addition, in the examples, "parts" represents "parts by weight", unless otherwise specified.

### (Examples 1 - 4, and Comparative example 1)

### <Preparation of support>

A 0.3 mm thick aluminum plate (material 1050, refining H16) was degreased at 65° C for one minute in an aqueous 5% sodium hydroxide solution, and subsequently washed with water.

This degreased aluminum plate was immersed at 25° C for one minute in an aqueous 10% sulfuric acid solution to neutralize, and then washed with water.

Next, the resulting aluminum plate was electrolytically etched to roughen the surface at 25° C for 20 seconds using an alternating current at a current density of 50 A/dm² and at a frequency of 50 Hz in an aqueous 11 g/liter hydrochloric acid solution, washed with water, desmutted at 50° C for 10 seconds in a 1% sodium hydroxide solution, washed with water, neutralized at 50° C for 30 seconds in a 30 % sulfuric acid solution, and washed with water.

Next, the desmutted aluminum plate was anodized at 25 °C for 30 seconds at a current density of 30 A/dm² and at a voltage of 25 V in a 30% sulfuric acid solution, and washed with water.

The resulting anodized aluminum plate was immersed in a 0.44% polyvinyl phosphonic acid aqueous solution at 75° C for 30 seconds, washed with pure water, and dried blowing cool air. Thus, a support for a photopolymerizable photosensitive planographic printing plate was obtained. The center line average surface roughness (Ra) of the support was 0.50 µm. (Preparation of photosensitive printing plate material)

The photopolymerizable image formation layer coating liquid 1, composed as described below, was applied onto the above support, employing a wire bar coater to result in a dried coated weight of 1.2 g/m², and subsequently dried at 95 °C for 1.5 minutes, whereby a photopolymerizable image formation layer coating sample was obtained.

| (Photopolymerizable image formation layer coating liquid 1) | |
|---|---|
| Polymerizable ethylenic double bond-containing monomer M-1 having a tertiary amino group in a molecule (described before) | 25.0 parts |
| The other polymerizable ethylenic double bond-containing monomer (Polyethylene glycol dimethacrylate NK ESTER-4G, produced by Shinnakamura Kagaku Kogyol Co., Ltd.) | 15.0 parts |
| Photopolymerizable initiator η-cumene-(η-cyclopentadienyl)iron Hexafluorophosphate | 3.0 parts |
| Photopolymerizable initiator (BR43) | 1.5 parts |
| Spectral sensitizing dye D7 (described before)4.0 | parts |
| Water-soluble polymeric compound-1 (described below) | 40.0 parts |
| N-phenylglycine bebzil ester | 4.0 parts |
| Phthalocyanine pigment (MHI454, produced by Mikuni Color Co.) | 6.0 parts |
| Infrared dye 1 | Quantity described in Table 1 |
| 2-t-butyl-6-(3-t-butyl-2-hydroxy-5-methylbenzil)-4-methylphenylacrylate (Sumirizer GS, produced by Sumitomo 3M Co., Ltd.) | 0.5 parts |
| Fluorine based surfactant (F-178K, produced by Dainippon ink Kagaku Kogyo Co., Ltd.) | 0.5 parts |
| Methylethyl ketone | 10.0 parts |
| Cyclohexanone | Quantity to make 1000 parts including the above-described amount |

| | |
|---|---|
| Water-soluble polymeric compound-1: vinyl pyrrolidone-vinyl acetate copolymer (60/40) Weight average molecular weight of 34000 (Luviskol 64, produced by BASF Japan Co., Ltd., VP/VA = 60% by weight/40% by weight copolymer) | |

The oxygen shielding layer coating solution 1 having the following composition was coated onto the above-described photopolymerizable image formation layer coated sample so as to give a dry thickness of 1.1 g/m² employing an applicator, and dried at 75 °C for 1.5 minutes to obtain a photosensitive planographic printing plate material having an oxygen shielding layer provided on an image formation layer.

| (Oxygen shielding layer coating liquid 1) | |
|---|---|
| Polyvinyl alcohol (GL-05, produced by Nippon synthetic chemical industry Co., Ltd.) | 82.5 parts |
| Polyvinyl pyrrolidone (k-30, produced by BASF Japan Co., Ltd.) | 12 parts |
| Surfactant (SURFINOL 465, produced by Nissin Chemical Corp.) | 0.5 parts |
| Infrared dye 2 | Quantity described in Table 1 |
| Water | 900 parts |

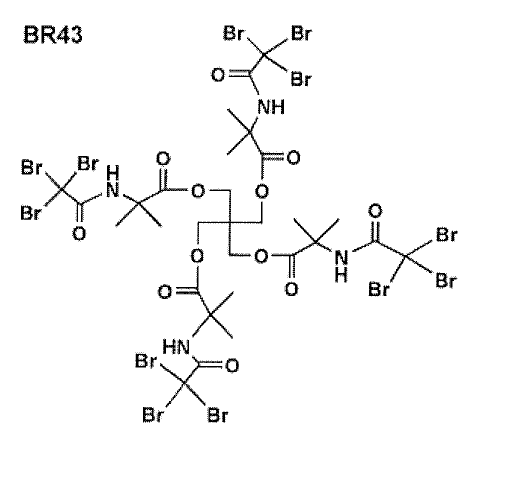

### Infrared dye 1

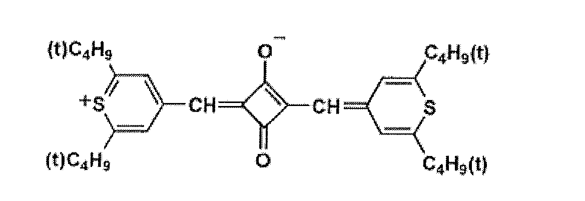

### Infrared dye 2

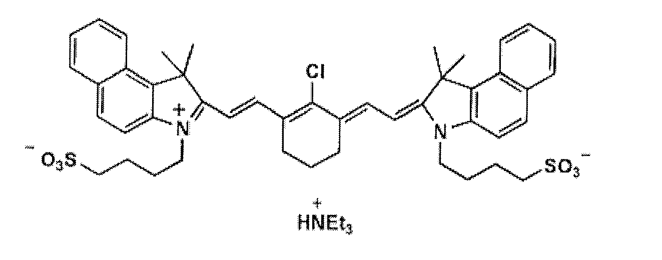

### <Printing evaluation>

The resulting photosensitive planographic printing plate material was mounted on a plate cylinder of a printing press as shown in Fig. 1, and imagewise exposed to laser light as the first laser light having a power of 100 mW and an exposure wavelength of 405 nm at a resolution of 2,400 dpi (The term, "dpi" shows the number of dots per 2.54 cm) with exposure energy of 200 µJ/cm² cm² to form an image with a screen number of 175 lines. At the same time, the entire surface exposure was conducted employing the second laser light for a heating process having an exposure wavelength of 830 nm and a laser beam spot diameter of 18 µm with exposure energy of 250 mJ/cm², or imagewise exposure (described in Table 1) in the same manner as in the first laser light exposure was conducted to form images (Examples 1 - 4 and Comparative example 1).

The exposed images include a solid image, and a dot image with a dot area of 1 - 99%.

The printing plate material having been subjected to image formation was directly on press and applied to the printing process, and a developing treatment was conducted employing the following dampening water and printing ink to produce a printing plate and to start printing.

Coated paper sheets were printed employing an aqueous 2% by weight solution of Astromark 3 (produced by Nikken Kagaku Kenkyusho) as dampening water and soybean type ink TK Hyecho SOY1 Magenta, produced by TOYO INK MFG. Co., Ltd. as ink.

Printing was started in the same printing sequence as in a conventional PS plate. When observing the printed surface after printing was completed, non-image portions of the printing plate sample were eliminated with no problem.

### (Printing durability)

The reproduction area of dot images at the beginning of printing was evaluated, and the number of prints printed till when dot reduction of 2% at highlight image portions was generated was visually observed was measured as a measure of printing durability.

### (Image reproduction)

The area where the original dots are reproduced on a printing plate was visually observed as a measure of image reproduction.

The reproduction area on a printing plate means the area where the original dots are reproduced with no dot defect generated (images are damaged). The larger the area is, the superior the image reproduction is.

### Results are shown in Table 1.

As is clear from Table 1, it is to be understood that the plate-making method of the present invention exhibits excellent printing durability and excellent image reproduction.

**Table 1**

| Example/ Comparative example | Infrared dye 1 (Parts) | Infrared dye 2 (Parts) | Exposure method with the second laser | Dot reproduction | Printing durability (Number of sheets) |
|---|---|---|---|---|---|
| Example 1 | 5.0 | - | Entire surface | 3.5-95.0 | 200000 |
| Example 2 | 5.0 | - | Imagewise | 2.0-98.0 | 200000 |
| Example 3 | 5.0 | 2.0 | Imagewise | 1.0-98.0 | 240000 |
| Example 4 | - | 5.0 | Imagewise | 2.0-98.0 | 200000 |
| Comparative example 1 | 5.0 | - | Non | 8.0-98.0 | 5000 |

### (Example 5)

The printing plate material was prepared to conduct a plate-making and printing, similarly to preparation of Example 2, except that a laser for heating in Example 2 was placed at a position shown in Fig. 2, and exposure to the second laser for heating was conducted 0.1 seconds after imagewise exposure. In the same evaluation as in Example 2, the dot reproduction area and printing durability resulted in a dot area of 2.0 - 98.0% and 200000, respectively. As is clear from this, it is to be understood that the plate-making method exhibits excellent printing durability as well as excellent image reproduction.

## Claims

1. A plate-making method of a planographic printing plate comprising the steps of:
imagewise exposing a printing plate material comprising a support and provided thereon, an on-press developable image formation layer to light; and
conducting a development treatment on a planographic printing press to prepare the planographic printing plate,
wherein laser light for the imagewise exposure has a wavelength of 350 - 450 nm, and laser light for a heating process conducted before the development treatment has a wavelength of 700 - 1500 nm.

2. The plate-making method of a planographic printing plate of Claim 1,
wherein heating in the heating process is conducted in 0.1 seconds before or after the imagewise exposure.

3. The plate-making method of a planographic printing plate of Claim 2,
wherein the heating in the heating process and the imagewise exposure are conducted at the same time.

4. The plate-making method of a planographic printing plate of any one of Claims 1 - 3,
wherein the heating process is an imagewise heating process with laser light.

5. The plate-making method of a planographic printing plate of any one of Claims 1 - 4,
wherein the image formation layer comprises (A) a photopolymerizable initiator, (B) a binder, (C) a polymerizable ethylenic unsaturated bond-containing compound and (D) a dye exhibiting an absorption maximum in a wavelength of 350 - 450 nm.

6. The plate-making method of a planographic printing plate of any one of Claims 1 - 5,
wherein the binder is a water-soluble polymeric compound.

7. The plate-making method of a planographic printing plate of any one of Claims 1 - 6,
wherein the image formation layer comprises a light-to-heat conversion material.

8. The plate-making method of a planographic printing plate of any one of Claims 1 - 7,
wherein the imagewise exposure is conducted on a printing press.

9. An imagewise exposure device used in the plate-making method of a planographic printing plate of any one of Claims 1 - 8, comprising a device of imegewise exposure to laser light having a wavelength of 350 - 450 nm and a device of exposure to laser light having a wavelength of 700 - 1500 nm.
